(19) Europäisches Patentamt
European Patent Office
Office européen des brevets

(11) EP 0 463 485 B1

(12) # EUROPÄISCHE PATENTSCHRIFT

(45) Veröffentlichungstag und Bekanntmachung des Hinweises auf die Patenterteilung:
**02.05.1997 Patentblatt 1997/18**

(51) Int Cl.⁶: **G03F 7/32**

(21) Anmeldenummer: **91109675.8**

(22) Anmeldetag: **13.06.1991**

(54) **Verfahren zur Herstellung photopolymerer flexographischer Reliefdruckplatten**

Process for the production of flexographic relief printing plates

Procédé pour la fabrication de plaques d'impression flexographiques à relief

(84) Benannte Vertragsstaaten:
**BE CH DE FR GB IT LI NL**

(30) Priorität: **27.06.1990 DE 4020374**

(43) Veröffentlichungstag der Anmeldung:
**02.01.1992 Patentblatt 1992/01**

(73) Patentinhaber: **BASF Aktiengesellschaft
67063 Ludwigshafen (DE)**

(72) Erfinder:
- **Telser Thomas, Dr.
W-6940 Weinheim (DE)**
- **Bach, Helmut, Dr.
W-6702 Bad Duerkheim (DE)**

(56) Entgegenhaltungen:
**EP-A- 0 177 905**
**EP-A- 0 228 676**
**EP-A- 0 316 618**
**EP-A- 0 332 070**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 463 485 B1

## Beschreibung

Die vorliegende Erfindung betrifft ein verbessertes Verfahren zur Herstellung photopolymerer flexographischer Reliefdruckplatten aus lichtempfindlichen Aufzeichnungselementen, welche

A) einen dimensionsstabilen Träger und

B) mindestens eine photopolymerisierbare Aufzeichnungsschicht mit

$b_1$) mindestens einem elastomeren Polymeren als Bindemittel,
$b_2$) mindestens einem photopolymerisierbaren Monomeren, welches mit dem Bindemittel ($b_1$) verträglich ist, und
$b_3$) mindestens einem Photopolymerisationsinitiator

enthält, durch

(1) bildmäßiges Belichten der photopolymerisierbaren Aufzeichnungsschicht (B) mit aktinischem Licht und

(2) Auswaschen (Entwickeln) der nicht belichteten und daher nicht photopolymerisierten Bereiche der bildmäßig belichteten Aufzeichnungsschicht (B) mit einem organischen Entwicklerlösungsmittel unter Bildung einer Reliefschicht.

Ein solches Verfahren ist, sieht man von der erfindungsgemäßen Verbesserung ab, allgemein bekannt. Üblicherweise sind dabei stets als Entwicklerlösungsmittel

(i) chlorierte Kohlenwasserstoffe wie Chloroform, Trichlorethylen, Tetrachlorethylen oder Trichlorethan als solche oder als Gemische mit niederen Alkoholen wie n-Butanol;

(ii) gesättigte cyclische und acyclische Kohlenwasserstoffe wie Petrolether, Hexan, Heptan, Octan, Cyclohexan oder Methylcyclohexan;

(iii) aromatische Kohlenwasserstoffe wie Benzol, Toluol oder Xylol; oder

(iv) niedere aliphatische Ketone wie Aceton, Methylethylketon oder Methylisobutylketon verwendet worden.

Für diese bekannten Verfahrensweisen ist es stets nachteilig gewesen, daß man die Entwicklerlösungsmittel hat lange einwirken lassen müssen, um eine befriedigende Auswaschwirkung zu erzielen. Dabei sind die Reliefschichten häufig angequollen worden, oder Teile des Reliefs sind unterwaschen und unter Umständen mechanisch abgelöst worden. Außerdem sind bei der Verwendung üblicher gesättigter oder aromatischer Kohlenwasserstoffe und Ketone lange Trocknungszeiten notwendig gewesen, und häufig ist es dabei zu der gefürchteten "positiven inneren Zurichtung" gekommen, d.h. die feineren Bildelemente haben über das Niveau von Volltonflächen herausgeragt. Nicht zuletzt weisen diese Entwicklerlösungsmittel bis auf die chlorierten Kohlenwasserstoffe niedrige Flammpunkte von kleiner als 21°C auf, was die Verwendung besonderer explosionsgeschützter Anlagen zur Durchführung des Verfahrens notwendig gemacht hat. Andererseits ist es bei der Verwendung chlorierter Kohlenwasserstoffe wegen ihrer Toxizität zu Entsorgungsproblemen gekommen. Zwar weisen diese Entwicklerlösungsmittel ein vorzügliches Lösevermögen auf, indes haben die photopolymeren flexographischen Reliefdruckplatten, welche mit Hilfe dieser Entwicklerlösungsmittel hergestellt worden sind, einen unbefriedigenden Flankenaufbau und eine auffallende, runzelige Oberflächenstruktur, die sogenannte Orangenhaut, aufgewiesen.

Inzwischen sind aber die Ansprüche, welche an das anwendungstechnische Eigenschaftsprofil photopolymerer flexographischer Reliefdruckplatten in der Praxis gestellt werden, stetig weiter gewachsen. So erwartet man heutzutage von photopolymeren flexographischen Reliefdruckplatten, daß sie sich in besonders einfacher, umweltschonender, zuverlässiger Weise aus lichtempfindlichen Aufzeichnungselementen herstellen lassen, nach ihrer Herstellung die Bildvorlage vollkommen detailgetreu wiedergeben, ozonresistent sind, keine klebrige Oberfläche aufweisen, unter Druckbedingungen gegenüber den Lösungsmitteln der üblicherweise verwendeten Flexodruckfarben beständig sind und exzellente Druckerzeugnisse in besonders hoher Auflage liefern. Dieses Anforderungsprofil ist nicht nur von der stofflichen Zusammensetzung der jeweils verwendeten lichtempfindlichen Aufzeichnungselemente abhängig, sondern auch von der Art und Weise ihrer Weiterverarbeitung zu photopolymeren flexographischen Reliefdruckplatten. Es besteht daher der Zwang, die bislang bekannten Verfahrensweisen immer weiter zu entwickeln, um mit den stetig anwachsenden Ansprüchen der Praxis Schritt halten zu können.

So ist aus der EP-A-0 228 676 (US-A-4 806 452) ein Verfahrens bekannt, bei welchem man verzweigte oder unverzweigte, einfach bis dreifach olefinisch ungesättigte acyclische Kohlenwasserstoffe, Alkohole oder Ketone mit 8 bis 15 Kohlenstoffatomen und/oder gesättigte oder einfach bis dreifach olefinisch ungesättigte cyclische aliphatische Kohlenwasserstoffe, Alkohole oder Ketone mit 8 bis 15 Kohlenstoffatomen im Molekül als wesentliche Bestandteile der organischen Entwicklerlösungsmittel verwendet. Dabei werden als Beispiele geeigneter Kohlenwasserstoffe, Alkohole oder Ketone mit 8 bis 15 Kohlenstoffatomen 1-Octen, Cyclooctan, Cycloocten, Cyclooctanol, Cyclooctanon, 3-Nonen, Mono- und Sesquiterpene oder Terpentinöle genannt. Von diesen werden die Monoterpene wie beispielsweise p-Menthan, Borneol, Menthon, D- und L-Limonen, α-Terpineol, α-Terpinen, γ-Terpinen, Terpinolen, α-Pinen, β-Pinen, δ-Pinen und Citronellol als vorteilhaft bezeichnet. Die organischen Entwicklerlösungsittel, welche mindestens eine dieser Verbindungen, insbesondere aber Limonen, enthalten, können, bezogen auf ihre Gesamtmenge, etwa bis zu 40 Gew.-% an anderen Lösungsmitteln enthalten. Hierbei sollen die vom vorstehend angegebenen Stand der Technik her bekannten, insbesondere aber höhersiedende Alkohole in einer Menge von bis zu 20 Gew.-%, in Betracht kommen.

Zwar kann dieses bekannte Verfahren in nicht explosionsgeschützten Waschern durchgeführt werden und liefert dabei gute bis sehr gute photopolymere flexographische Reliefdruckplatten, indes weisen die bei diesem Verfahren verwendeten organischen Entwicklerlösungsmittel einen so intensiven Eigengeruch auf, daß die Durchführung des Verfahrens nur in besonders intensiv belüfteten Fabrikräumen möglich ist, eine Beschränkung, welche einen schwerwiegenden Nachteil darstellt.

Hier hat das aus der EP-A-0 332 070 bekannte Verfahren einen gewissen Fortschritt mit sich gebracht. Bei diesem bekannten Verfahren werden als organische Entwicklerlösungsmittel hydrierte Erdölfraktionen eines Siedebereiches zwischen 160 und 220°C und eines Flammpunktes von über 45°C verwendet. Diese hydrierten Erdölfraktionen sollen einen Aromatengehalt von kleiner 1 % und einen Anteil an naphthenischen Kohlenwasserstoffen zwischen 0,5 und 50 % aufweisen. Solche Produkte sind üblich und bekannt und werden beispielsweise von der Firma Exxon unter den Handelsnamen oder Warenzeichen "Exxsol D", "Nappar", "Norpar" oder "Isopar", von der Firma Esso unter dem Handelsnamen oder Warenzeichen "Shellsol D" oder von der Firma Hydrocarbures unter dem Handelsnamen oder Warenzeichen "Hydrosol P "vertrieben.

Diese organischen Entwicklerlösungsmittel sollen außerdem Alkohole mit einer Kohlenstoffanzahl von 4 bis 8 wie n-Butanol, n-Pentanol, Isobutanol oder Hexanol enthalten können. Dabei soll der Anteil mindestens 5 Vol.%, vorzugsweise 20 Vol.%, betragen. Darüber hinaus sollen diesem bekannten organischen Entwicklerlösungsmittel noch oberflächenaktive Substanzen (Detergentien) wie Alkylsulfonate und deren Salze, Alkylammoniumsalze, ethoxylierte Fettalkohole, Fettalkoholethersulfate und deren Salze sowie Fettalkoholphosphorsäureester und deren Salze, welche indes nicht näher spezifiziert werden, in einer Menge von bis bis zu 2 Gew.-% oder geruchsverbessernde Zusatzstoffe wie Limonen, Pinen oder Citronellol in einer Menge von bis zu 10 Gew.-% zugegeben werden können.

Zwar wirft dieses bekannte Verfahren keine so schwerwiegenden Geruchsprobleme wie das aus der EP-A-0 228 676 bekannte auf und liefert auch gute bis sehr gute photopolymere flexographische Reliefdruckplatten, welche eine hervorragende druckende Oberfläche ohne Orangenhaut und - wenn überhaupt - nur eine geringe Quellung aufweisen, indes kann es bei der Verwendung dieser organischen Entwicklerlösungsmittel verstärkt zu einer elektrostatischen Aufladung der im Wascher bewegten Flüssigkeit kommen, was schwerwiegende sicherheitstechnische Probleme aufwirft. Dies kann u.a. auch dazu führen, daß die Waschbedingungen nicht weiter verschärft werden können (z.B. durch Erhöhen des Sprühdrucks oder der Bürstengeschwindigkeit), sondern die Entwicklung abgebrochen werden muß.

Aus der US-A-4 847 182 ist eine Variante des Verfahrens bekannt, welches aus der EP-A-0 228 676 hervorgeht. Bei dieser Verfahrensvariante werden den in der Hauptsache aus Terpenen bestehenden organischen Entwicklerlösungsmitteln sogenannte "Nicht-Lösungsmittel" wie n-Butanol, 2-Ethoxiethanol, Benzylalkohol, Ethanol, 2-Butoxiethanol, Isopropylalkohol, 2-(2-Butoxiethoxi)-ethanol, Mineralöl, "mineral spirits", Ligroin, Decan oder Octan zugesetzt. Diese "Nicht-Lösungsmittel" sollen das Ausfallen der ausgewaschenen Materialien aus dem jeweils verwendeten organischen Entwicklerlösungsmittel bewirken, so daß dessen Aufarbeitung vereinfacht wird. Des weiteren wird empfohlen, die Terpene und die "Nicht-Lösungsmittel" in der Form wäßriger Emulsionen zu verwenden. Wie aus den Beispielen der US-A-4 847 182 weiter hervorgeht, müssen dabei große Mengen an oberflächenaktiven Substanzen mitverwendet werden. Zwar kann es bei der Verwendung von wäßrigen Emulsionen zu keiner elektrostatischen Aufladung mehr kommen, indes vermag dieses Verfahren nicht die Probleme zu lösen, welche mit dem intensiven Geruch der hierbei verwendeten Terpene verbunden sind. Außerdem bereitet die Herstellung der Emulsionen in der Praxis häufig große Schwierigkeiten, weil sie in den üblicherweise verwendeten Waschern sehr stark zum Schäumen neigen.

Aus der EP-A-0 355 789 ist ein Verfahren bekannt, für welches die organischen Entwicklerlösungsmittel aus den folgenden Verbindungsklassen ausgewählt werden:

(i) Diethylenglykoldialkylether mit Alkylgruppen, welche 1 bis 5 Kohlenstoffatome enthalten;

(ii) Essigsäureester von gesättigten, 6 bis 10 Kohlenstoffatome enthaltenden Alkoholen oder von 6 bis 10 Kohlenstoffatome enthaltenden, alkoxisubstituierten gesättigten Alkoholen;

(iii) Carbonsäureester von 6 bis 10 Kohlenstoffatome enthaltenden Carbonsäuren und 1 bis 6 Kohlenstoffatome enthaltenden Alkoholen sowie

(iv) Ester von 2 bis 4 Kohlenstoffatome enthaltenden, alkoxisubstituierten Carbonsäuren, worin der Alkoxirest 1 bis 4 Kohlenstoffatome aufweist, und einem 1 bis 4 Kohlenstoffatome enthaltenden Alkohol.

Hiervon sollen Diethylenglykoldiethylether, Essigsäure-3,5,5-trimethylhexylester, Essigsäure-2-butoxiethylester (Butylglykolacetat), Essigsäure-2-ethylbutylester, Essigsäure-2-cyclohexylethylester, Essigsäure-2-ethylhexylester oder Mischungen hiervon, Octansäureethylester, Hexansäure-2-pentylester, Nonansäureethylester oder 3-Ethoxipropionsäureethylester vorteilhaft sein. Von diesen wiederum sollen 3-Ethoxipropionsäureethylester, Gemische aus Essigsäurenonylestern, Essigsäure-2-ethylhexylester und Diethylenglykoldiethylether oder Gemische aus Essigsäure-3,5,5-trimethylhexylester, Essigsäure-2-ethylhexylester und Diethylenglykoldiethylether besonders bevorzugt verwendbar sein. Außerdem sollen diese organischen Entwicklerlösungsmittel noch 5 bis 40 Volumen- oder Gewichtsprozent, welches hiervon zutrifft bleibt offen, an Alkoholen wie Butanol, Benzylalkohol oder 2-Ethylhexanol enthalten.

In der betrieblichen Praxis ist die Verwendung der Ester als organische Entwicklerlösungsmittel von großem Nachteil, weil jeder Vertreter dieser Verbindungsklasse den für ihn jeweils typischen intensiven fruchtigen Estergeruch aufweist. Dieser intensive Geruch führt zu schwerwiegenden Beeinträchtigungen des Personals im reprographischen Betrieb, welches den schon fast sprichwörtlich intensiven Estergeruch nach einer gewissen Zeit nachgerade als unerträglich empfindet. Ein weiterer Nachteil des aus der EP-A-0 355 789 bekannten Verfahrens ist, daß die hierbei verwendeten organischen Entwicklerlösungsmittel eine sehr starke Quellung der entwickelten bildmäßig belichteten Aufzeichnungsschichten (B) bewirken und die in hohem Maße unerwünschte Orangenhaut auf der druckenden Oberfläche der photopolymeren flexographischen Reliefdruckplatten hervorrufen.

Diese Nachteile treten auch bei dem aus der DE-A-38 36 402 bekannten Verfahren auf, bei welchem Ester der allgemeinen Formel IV verwendet werden sollen,

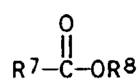

(IV)

worin $R^7$ und $R^8$ gleich oder verschieden sein können und n- oder iso-Alkylreste mit 1 bis 13 Kohlenstoffatomen, Cycloalkylreste mit 5, 6 oder 12 Kohlenstoffatomen, Alkylarylreste mit 1 bis 3 Kohlenstoffatomen im Alkylrest und 6 Kohlenstoffatomen im Arylrest oder Arylreste mit 6 bis 10 Kohlenstoffatomen bezeichnen, wobei die Summe der Kohlenstoffatome in den Resten $R^7$ und $R^8$ 6 bis 13 beträgt. Hierbei sollen vor allem Essigsäure-amyl-, Essigsäure-i-amyl-, Essigsäure-hexyl-, Essigsäure-cyclohexyl-, Essigsäure-ethylhexyl-, Essigsäure-nonyl-, Essigsäure-i-nonyl-, Propionsäure-propyl-, Buttersäure-propyl-, Buttersäure-butyl-, Buttersäure-i-butyl-, Essigsäure-benzyl- oder Benzoesäuremethylester verwendet werden -allesamt Verbindungen mit intensivem Geruch, verbunden mit einer niedrigen elektrischen Leitfähigkeit.

Weitere Verfahren sind aus der DE-A-38 36 404 und der DE-A-38 36 403 bekannt.

Bei dem Verfahren der DE-A-38 36 404 sollen Phenolether der allgemeinen Formel V

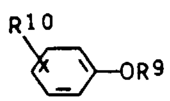

(V)

worin $R^9$ einen n- oder iso-Alkylrest mit 1 bis 6 Kohlenstoffatomen, einen Cycloalkylrest oder einen Arylrest mit 6 bis 12 Kohlenstoffatomen und $R^{10}$ ein Wasserstoffatom oder einen n- oder iso-Alkylrest mit 1 bis 6 Kohlenstoffatomen oder einen Rest $-OR^9$ bezeichnet, verwendet werden. Hiervon sollen Methylphenyl-, Ethylphenyl-, Isopropylphenyl-, Propylphenyl-, o-Kresylmethyl, m-Kresylmethyl-, p-Kresylmethyl-, Resorcindimethyl- und Brenzkatechinethylether vorteilhaft sein.

Demgegenüber macht das Verfahren der DE-A-38 36 403 von Aromaten der allgemeinen Formel VI Gebrauch,

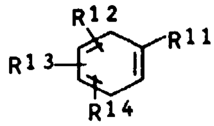

(VI)

worin $R^{11}$ bis $R^{14}$ gleich oder verschieden sein können und Wasserstoffatome oder n- oder iso-Alkylreste mit 1 bis 5 Kohlenstoffatomen bedeuten, wobei $R^{11}$ und $R^{12}$, sofern sie direkt benachbart sind, auch einen cycloaliphatischen Ring mit 5 bis 6 Ringkohlenstoffatomen ausbilden können, wobei letztere vorzugsweise nicht substituiert sind und wobei die Summe der Kohlenstoffatome der Substituenten und der Ringglieder 9 bis 13 ist. Hiervon sollen vor allem Isopropylbenzol, n-Propylbenzol, 1-Methyl-3-ethylbenzol, 1,3,5-Trimethylbenzol, 1-Methyl-2-ethylbenzol, 1,2,4-Trimethylbenzol, Isobutylbenzol, sec.-Butylbenzol, 1,2,3-Trimethylbenzol, 1-Methyl-4-isopropylbenzol, Indan, Inden, 1,3-Diethylbenzol, 1-Methyl-4-propylbenzol, n-Butylbenzol, 1-Methyl-3-propylbenzol, 1,2,4,5-Tetramethylbenzol, Dimethylethylbenzol, Methylinden oder n-Pentylbenzol angewandt werden.

Diese beiden Verfahren machen zwar von Verbindungen Gebrauch, welche nicht ganz so intensiv wie die Ester, dafür aber zum Teil recht unangenehm riechen. Dadurch kann, allerdings nur graduell, die besonders intensive Geruchsbelästigung durch die Ester gemildert werden. Es verbleibt jedoch der schwerwiegende Nachteil, daß es sich bei den Entwicklerlösungsmitteln der DE-A-38 36 404 und der DE-A-38 36 403 ausschließlich um aromatische Lösungsmittel handelt, welche letztlich allesamt mehr oder weniger große toxikologische, arbeitshygienische, sicherheitstechnische und ökologische Probleme aufwerfen und welche eine ausgesprochen niedrige elektrische Leitfähigkeit haben und sich deshalb besonders leicht elektrostatisch aufladen.

Ansonsten werden in den beiden nicht vorveröffentlichten älteren deutschen Patentanmeldungen P 3908764.6 und P 3908763.8 Verfahren der eingangs genannten Art beschrieben, bei welchen Emulsionen aus organischen Entwicklerlösungsmitteln und Wasser verwendet werden. Hierbei kommen als organische Entwicklerlösungsmittel chlorierte Kohlenwasserstoffe, gesättigte und/oder ungesättigte cyclische Kohlenwasserstoffe, gesättigte und/oder ungesättigte acyclische Kohlenwasserstoffe, Petroleumdestillate, hydrierte Erdölfraktionen und/oder deren Gemische in Betracht, sofern sie jeweils für sich selbst gesehen bereits nichtbrennbar, schwerbrennbar und/oder hochsiedend sind. Außerdem kommen Gemische langkettiger Alkylester mit Alkylgruppen unterschiedlicher Kettenlänge, welche indes nicht näher spezifiziert werden, in Betracht. Diese Emulsionen können außerdem noch 0,1 bis 20 Vol.% mindestens eines Alkohols wie etwa n-Butanol, n-Pentanol, n-Hexanol, Cyclohexanol, n-Heptanol, n-Octanol, n-Decanol, Laurylalkohol, 3-Methyl-3-methoxibutanol, Benzylalkohol oder 2,3,5-Trimethylhexanol enthalten.

Im allgemeinen weisen die lichtempfindlichen Aufzeichnungselemente, welche sich für die Herstellung von photopolymeren flexographischen Reliefdruckplatten eignen und welche von der Fachwelt folglich etwas ungenau als "Flexodruckplatten" bezeichnet werden, eine alkohol- oder wasserlösliche Deckschicht (C) auf, welche der photopolymerisierbaren Aufzeichnungsschicht (D) unmittelbar aufliegt und verhindert, daß die zum Zwecke der bildmäßigen Belichtung mit aktinischem Licht auf die Flexodruckplatten aufgelegten Negativvorlagen auf der Oberfläche der photopolymerisierbaren Aufzeichnungsschichten (B) festkleben.

Häufig bestehen die alkohollöslichen Deckschichten (C) aus einem Polyamid, wie z.B. Macromelt® der Firma Henkel, wogegen die wasserlöslichen Deckschichten (C) vor allem aus Polyvinylalkohol, wie z.B. Mowiol® der Firma Hoechst, bestehen.

Den organischen Entwicklerlösungsmitteln müssen deshalb entweder Alkohole bzw. Wasser zugesetzt werden, damit die Deckschichten (C) im Entwicklungsschritt mit weggewaschen werden, oder aber die Deckschichten (C) werden in einem separaten Waschgang mit Alkoholen bzw. Wasser entfernt, was in der Praxis auch als "prewipe" bezeichnet wird.

Je nachdem, welche bildmäßig belichteten Flexodruckplatten man mit welchen Methoden entwickelt, ergeben sich spezifische Nachteile, die bislang noch nicht gelöst worden sind:

1. Flexodruckplatten mit alkohollöslichen Deckschichten (C)

1.1 Wenn die Flexodruckplatte eine alkohollösliche Deckschicht (C) enthält, werden den organischen Entwicklerlösungsmitteln im allgemeinen n-Butanol, iso-Butanol, n-Pentanol oder Hexanol zugesetzt (vgl. z.B. die EP-A-0 332 070). Hierbei handelt es sich demnach um Alkohole mit geradkettigem Alkylrest im Molekül und einem Siedepunkt unterhalb 160°C oder um gesättigte Alkohole mit einem verzweigten Alkylrest im Molekül, welche indes einen Siedepunkt unterhalb 150°C haben. Diese Alkohole setzen den Flammpunkt des organischen Entwicklerlösungsmittels drastisch herab und sie haben einen intensiven unangenehmen Geruch. Außerdem bereiten diese Alkohole bei der Aufarbeitung gebrauchter organischer Entwicklerlösungsmittel durch Destillation Schwierigkeiten, weil sie sich wegen ihrer vergleichsweise niedrigen Siedepunkte oder Siedebereiche

im Destillat anreichern, so daß dessen Zusammensetzung laufend überwacht und neu eingestellt werden muß, damit das Destillat als organisches Entwicklerlösungsmittel wiederverwendet werden kann. Dies alles führt in der Praxis zu schwerwiegenden sicherheitstechnischen, arbeitshygienischen und ökologischen Problemen.

1.2 Versucht man den Folgen der Herabsetzung des Flammpunktes, der Geruchsbelästigung oder der Unterschiede in den Siedepunkten oder Siedebereichen dadurch zu begegnen, daß man höhersiedende Alkohole wie z.B. n-Heptanol oder n-Octanol verwendet, handelt man sich damit neue Probleme ein: die betreffenden organischen Entwicklerlösungsmittel sind dann zwar weitgehend geruchlos, sie vermögen jedoch nicht mehr, die Deckschicht (C) einwandfrei zu entfernen, und sie laden sich sehr leicht elektrostatisch auf, was ein besonders gravierender Nachteil ist.

1.3 Versucht man, all diese Nachteile von vornherein auszuschalten, und wäscht zu diesem Zweck die alkohollösliche Deckschicht (C) mit einem Alkohol weg ("prewipe") und entwickelt erst danach die bildmäßig belichtete Flexodruckplatte mit dem alkoholfreien organischen Entwicklerlösungsmittel, dann ist dieses aufgrund seiner niedrigen elektrischen Leitfähigkeit erst recht sehr leicht elektrostatisch aufladbar, weswegen dieses gravierende Sicherheitsrisiko nach wie vor und sogar in erhöhtem Ausmaß besteht.
Davon abgesehen, verbleibt nach wie vor die Geruchsbelästigung durch die Alkohole während des "prewipe".

2. Flexodruckplatten mit wasserlöslicher Deckschicht (C)

2.1 Will man die wasserlöslichen Deckschichten (C) während des Entwicklungsschritts entfernen, muß man den organischen Entwicklerlösungsmitteln Wasser zusetzen, wie dies in der US-A-4 847 182 beschrieben wird, wobei man sich die bei der Diskussion dieses Standes der Technik bereits ausführlich dargestellten Nachteile einhandelt.

2.2 Entfernt man dagegen die wasserlöslichen Deckschichten (C) mittels "prewipe" und entwickelt danach mit dem reinen organischen Entwicklerlösungsmittel, ist man erneut bei den in Ziffer 1.3 ausführlich dargestellten Problemen angelangt.

Weitere Nachteile werden noch bei der Berücksichtigung des folgenden technischen Sachverhaltes deutlich:

Während des Auswaschens (Entwickelns) der bildmäßig belichteten Aufzeichnungsschichten (B) nehmen die belichteten und daher photopolymerisierten Bereiche der Aufzeichnungsschicht (B) Lösungsmittel auf. Dieser Vorgang wird üblicherweise als Quellung bezeichnet. Das Ausmaß der Quellung kann durch die separate Bestimmung der Schichtdickenzunahme und/oder der Gewichtszunahme der vollflächig belichteten und hiernach mit dem betreffenden Entwicklerlösungsmittel behandelten Aufzeichnungsschicht (B) quantifiziert werden. Im allgemeinen liegt in der Praxis die Quellung der bildmäßig belichteten und entwickelten Aufzeichnungsschichten (B), sprich der Reliefschichten, der photopolymeren flexographischen Reliefdruckplatten bei 5 bis 10 Gew.-%. In Schichtdicken umgerechnet, bedeutet dies beispielsweise bei einer 3 mm dicken lichtempfindlichen Aufzeichnungsschicht (B) bzw. bei der hieraus hergestellten Reliefschicht eine Schichtdickenzunahme von 150 bis 300 µm.

Durch die Trocknung soll nun das von der Reliefschicht der photopolymeren flexographischen Reliefdruckplatte aufgenommene organische Entwicklerlösungsmittel wieder entfernt werden. Hierbei wird in der Praxis oft der Fehler begangen, die Trocknung schon zu beenden, wenn die photopolymere flexographische Reliefdruckplatte bzw. deren Reliefschicht ihre Ausgangsdicke oder ihr Ausgangsgewicht wieder erreicht hat. Dabei wird übersehen, daß die ursprüngliche bildmäßig belichtete Aufzeichnungsschicht (B) während des Auswaschens (Entwickeln) nicht nur organische Entwicklerlösungsmittel aufnimmt, sondern auch niedermolekulare Bestandteile wie z.B. Weichmacher oder andere Hilfsstoffe gegen das organische Entwicklerlösungsmittel austauscht. Es findet somit gleichzeitig eine Quellung und eine Extraktion statt, was dazu führt, daß die üblicherweise angeführten Quellwerte nicht die Quellung als solche, sondern in Wirklichkeit die Summe aus Quellung und Extraktion wiedergeben.

Wird nun bei dem in Rede stehenden Verfahren ein organisches Lösungsmittel verwendet, bei welchem der Effekt der Extraktion besonders stark ausgeprägt ist, und werden die hiermit entwickelten photopolymeren flexographischen Reliefdruckplatten bis zur tatsächlichen Gewichts- oder Dickenkonstanz getrocknet, was im allgemeinen mehrere Tage erfordert, so wird das Ausgangsgewicht bzw. die Ausgangsschichtdicke der Reliefschicht der photoplymeren Reliefdruckplatte deutlich unterschritten.

Werden dagegen der üblichen Verfahrensweise entsprechend die photopolymeren flexographischen Reliefdruckplatten nur bis zum Erreichen des Ausgangsgewichts oder der Ausgangsschichtdicke getrocknet, dann enthalten ihre Reliefschichten notwendigerweise noch hohe Anteile an organischen Entwicklerlösungsmitteln. Diese Restlösungsmittel sind aber in den Reliefschichten ungleichmäßig verteilt. So weisen feine Strukturen wie z.B. Raster mit einer

großen Oberfläche pro Volumen erheblich höhere Quellwerte auf als Volltonflächen. Dies gilt auch für die Ränder dieser Volltonflächen, welche stärker angequellen als deren Mitte. Dies hat zur Folge, daß die feinen Strukturen und die Ränder der Volltonflächen in der Reliefschicht der photopolymeren flexographischen Reliefdruckplatte höher stehen als beispielsweise die Mitte der Volltonflächen. Diese Inhomogenitäten und unterschiedlichen Höhen (Toleranzen) werden vor allem durch die stets vorhandene ungleichmäßige Temperaturverteilung im Trockner mithervorgerufen und verstärkt. Nehmen diese Toleranzen in einer photopolymeren flexographischen Reliefdruckplatte überhand, bewirken sie deren Unbrauchbarkeit.

Selbst wenn die Menge des noch vorhandenen Restlösungsmittels nicht unmittelbar zur Unbrauchbarkeit der betreffenden photopolymeren flexographischen Reliefdruckplatte führt, bewirkt es immer noch den sogenannten Langzeitschrumpf, d.h. die Reliefschicht der betreffenden photopolymeren flexographischen Reliefdruckplatte verändert durch das Verdunsten des Restlösungsmittels bei längerer Lagerung oder längerem Gebrauch ihre Dimensionen. Wegen des Langzeitschrumpfes erhält man dann mit ein und derselben photopolymeren flexographischen Reliefdruckplatte nach längerer Lager- oder Gebrauchsdauer unterschiedliche Druckergebnisse, was für die Praxis nicht akzeptabel ist. Dieser Nachteil wird in der Praxis insbesondere dann akut, wenn nach längerer Gebrauchsdauer eine der vier photopolymeren flexographischen Reliefdruckplatten eines flexographischen Vierfarbensatzes nicht mehr mitverwendet werden kann und von jetzt auf nachher durch eine neu herzustellende, im Motiv und in ihrer Dimension identische Reliefdruckplatte ersetzt werden muß, welche den betreffenden Farbauszug zu den anderen drei Farbauszügen exakt passend druckt. Ein solcher rascher Ersatz ist aber nicht mehr möglich, wenn die photopolymeren flexographischen Reliefdruckplatten des Vierfarbensatzes einen Langzeitschrumpf erlitten haben, weil dann die neu hergestellte Reliefdruckplatte in ihren Dimensionen nicht mehr zu den übrigen drei paßt. Ist dies der Fall, bleibt nur noch der zeitraubende und teure Ausweg, alle vier Reliefdruckplatten des Vierfarbensatzes neu herzustellen.

Abgesehen davon, daß es in hohem Maße wünschenswert ist, die Nachteile der bislang bekannten Verfahren durch Variation ihrer Parameter, insbesondere der organischen Entwicklerlösungsmittel, zu vermindern oder gar ganz zu beseitigen, müssen bei der Erfolgskontrolle auch noch andere Meßmethoden angewandt werden. So sollte sich die notwendige Dauer der Trocknung nicht nach dem Erreichen der Ausgangsschichtdicke oder des Ausgangsschichtgewichts richten, sondern danach, wann die Toleranzen der Reliefschichten der photopolymeren Reliefdruckplatten einen Minimalwert erreicht haben, wobei die Angabe der Toleranzen noch durch eine Flächenangabe und die Angabe der Zahl der Meßstellen auf der Reliefschicht zu ergänzen wäre. Diese Angaben spezifizierten dann in ihrer Gesamtheit eine Trocknungszeit, bei welcher die Menge an Restlösungsmittel in der photopolymeren flexographischen Reliefdruckplatte einen Wert erreicht hätte, welcher die Brauchbarkeit der photopolymeren flexographischen Reliefdruckplatte unter Praxisbedingungen nicht mehr länger verminderte oder gar vollständig zunichte machte. Ohne solche detaillierten Angaben kann keine Erfolgskontrolle durchgeführt werden, und eine Vergleichbarkeit von organischen Entwicklerlösungsmitteln untereinander ist nicht gewährleistet.

Aufgabe der vorliegenden Erfindung ist es, das eingangs genannte Verfahren weiter zu entwickeln, um so zu einem neuen, verbesserten Verfahren zur Herstellung einer flexographischen Reliefdruckplatte aus einem lichtempfindlichen Aufzeichnungselement (Flexodruckplatte) zu gelangen, welches - auch unter Berücksichtigung exakter Vergleichskriterien - die vorstehend genannten Nachteile des Standes der Technik nicht mehr länger aufweist.

Zur Lösung dieser Aufgabe hat überraschenderweise die Erkenntnis beigetragen, daß bereits die Zugabe geringer Mengen eines Antistatikums zu den organischen Entwicklerlösungsmitteln neue und elegante Wege zur Problemlösung eröffnet, welche bislang als nicht gangbar erachtet wurden und/oder im Hinblick auf den Stand der Technik nicht zu erwarten waren. Zur Weiterentwicklung der Lösung dieser Aufgabe hat auch noch der überraschende Befund beigetragen, daß die Löslichkeit der alkohollöslichen Deckschicht (C) in gesättigten Alkoholen mit einem verzweigten Alkylrest im Molekül sehr viel höher ist als in den geradkettigen Homologen. Wegen dieses Befundes können nun in überraschend einfacher Weise Alkohole ausgewählt werden, deren Siedepunkt oder Siedebereich demjenigen des organischen Entwicklerlösungsmittels angepaßt ist, welche nahezu geruchlos sind und welche den Flammpunkt der organischen Entwicklerlösungsmittel überhaupt nicht oder nur sehr geringfügig erniedrigen.

Bei dem Gegenstand der vorliegenden Erfindung handelt es sich demnach um ein neues Verfahren zur Herstellung einer photopolymeren flexographischen Reliefdruckplatte aus einem lichtempfindlichen Aufzeichnungselement, welches

A) einen dimensionsstabilen Träger und

B) mindestens eine photopolymerisierbare Aufzeichnungsschicht mit

$b_1$) mindestens einem elastomeren Polymeren als Bindemittel,
$b_2$) mindestens einem photopolymerisierbaren Monomeren, welches mit dem Bindemittel $b_1$) verträglich ist, und
$b_3$) mindestens einem Photopolymerisationsinitiator

enthält, durch

(1) bildmäßiges Belichten der photopolymerisierbaren Aufzeichnungsschicht (B) mit aktinischem Licht und

(2) Auswaschen (Entwickeln) der nicht belichteten und daher nicht photopolymerisierten Bereiche der bildmäßig belichteten Aufzeichnungsschicht (B) mit einem organischen Entwicklerlösungsmittel unter Bildung einer Reliefschicht,

wobei das neue, verbesserte Verfahren dadurch gekennzeichnet ist, daß das hierbei verwendete organische Entwicklerlösungsmittel, schwerbrennbar, nichtbrennbar und/oder hochsiedend ist und, bezogen auf seine Gesamtmenge, 1 pphm (1 Teil pro 100.000.000) bis 3 Gew.-% mindestens eines Antistatikums aus der Gruppe

(i) der tertiären Amine und Amide der allgemeinen Formel I,

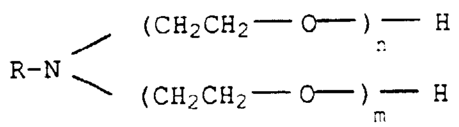

(I)

worin die Indices und die Variablen die folgende Bedeutung haben:

R $C_{12}$- bis $C_{18}$-Alkyl, $C_{18}$-Alkenyl, $C_{12}$- bis $C_{18}$-Alkancarbonyl oder $C_{18}$-Alkencarbonyl,

n eine ganze Zahl von 1 bis 15 und unabhängig hiervon

m eine ganze Zahl von 1 bis 15;

(ii) der quaternären Ammoniumsalze der allgemeinen Formel II,

$$[NR^1R^2R^3R^4]^{\oplus} X^{\ominus} \quad (II)$$

worin die Variablen die folgende Bedeutung haben:

$X^{\ominus}$ $Cl^{\ominus}$, $Br^{\ominus}$, $I^{\ominus}$, $R^1\text{-O-PO}_3H^{\ominus}$, $(R^1\text{-O})_2PO_2^{\ominus}$, $R^1\text{-PO}_3^{\ominus}$, $R^1\text{-SO}_3^{\ominus}$, $R^1\text{-COO}^{\ominus}$, $CF_3SO_3^{\ominus}$, $R^1\text{-OSO}_3^{\ominus}$,

$R^1$ $C_1$- bis $C_4$-Alkyl,

$R^2$ und $R^3$ $C_1$- bis $C_{20}$-Alkyl,
$-(\text{-}CH_2CH_2\text{-O-})_n\text{-H}$, worin n eine ganze Zahl von 1 bis 15 bezeichnet und wobei $R^2$ und $R^3$ gleich oder verschieden sein können,

$R^4$ $-(\text{-}CH_2CH_2\text{-O-})_n\text{-H}$, worin n eine ganze Zahl von 1 bis 15 bezeichnet,
$C_{12}$-, $C_{14}$-, $C_{16}$- und $C_{18}$-Alkyl,
3-Azatridecan-1-yl bis 3-Azadocosan-1-yl,
4-Azatridecan-1-yl bis 4-Azadocosan-1-yl,
3-Aza-4-oxo-tridecan-1-yl bis
3-Aza-4-oxo-docosan-1-yl,
4-Aza-5-oxo-tridecan-1-yl bis
4-Aza-5-oxo-docosan-1-yl,
3-Oxa-tridecan-1-yl bis 3-Oxa-docosan-1-yl,
4-Oxa-tridecan-1-yl bis 4-Oxa-docosan-1-yl,
2-Hydroxy-4-oxa-tridecan-1-yl bis 2-Hydroxy-4-oxa-docosan-1-yl;

(iii) der primären Etheramine der allgemeinen Formel III,

$$R^5\text{-O-}R^6\text{-}NH_2 \qquad (III)$$

worin die Variablen die folgende Bedeutung haben:

$R^5$ $C_6$- bis $C_{20}$-Alkyl und

$R^6$ $C_2$- bis $C_6$-Alkandiyl;

und/oder

(iv) der Alkali- Erdalkali- und/oder Übergangsmetallsalze von Aminocarbonsäuren enthält.

Bei einer vorteilhaften Verfahrensvariante des neuen, verbesserten Verfahrens zur Herstellung einer photopolymeren flexographischen Reliefdruckplatte aus einem lichtempfindlichen Aufzeichnungselement enthält das organische Entwicklerlösungsmittel außerdem noch mindestens einen in seinem Siedepunkt oder Siedebereich dem Siedebereich des Entwicklerlösungsmittels angepaßten, nahezu geruchlosen gesättigten Alkohol mit verzweigtem Alkylrest im Molekül und/oder Benzylalkohol.

Im folgenden wird das neue, verbesserte Verfahren zur Herstellung einer photopolymeren flexographischen Reliefdruckplatte aus einem lichtempfindlichen Aufzeichnungselement der Kürze halber als "erfindungsgemäßes Verfahren" bezeichnet.

Im Rahmen der vorliegenden Erfindung bedeutet "verträglich" die Eigenschaft zweier oder mehrerer Komponenten, vollständig miteinander mischbar zu sein und sich auch nicht nach längerer Lagerungszeit wieder zu entmischen.

Das erfindungsgemäß wesentliche Merkmal des erfindungsgemäßen Verfahrens ist die Verwendung eines organischen Entwicklerlösungsmittels, welches für den hier in Rede stehenden Zweck bislang noch nicht angewandt worden ist.

Das erfindungsgemäß zu verwendende organische Entwicklerlösungsmittel enthält, bezogen auf seine Gesamtmenge, 1 pphm (1 Teil pro 100.000.000) bis 3 Gew.-% mindestens eines Antistatikums. Dies bedeutet, daß der Gehalt des organischen Entwicklerlösungsmittels an Antistatika innerhalb weiter Grenzen variiert werden kann, ohne daß die mit Hilfe des erfindungsgemäßen Verfahrens erhaltenen besonderen Vorteile verlustig gehen. Innerhalb dieses weiten Bereiches hat sich ein Gehalt an Antistatikum von 1 ppm (1 Teil pro Million) bis 2 Gew.-% im Hinblick auf die anwendungstechnischen Eigenschaften der betreffenden organischen Entwicklerlösungsmittel als vorteilhaft herausgestellt. Erfindungsgemäß werden diejenigen organischen Entwicklerlösungsmittel ganz besonders bevorzugt verwendet, deren Gehalt an Antistatikum unterhalb 1 Gew.-%, vorteilhafterweise 0,01, insbesondere 0,001 Gew.-% liegt.

Erfindungsgemäß ist es von Vorteil, wenn die erfindungsgemäß zu verwendenden Entwicklerlösungsmittel eine elektrische Leitfähigkeit $\sigma \geq 100$ pS, insbesondere $\geq 1000$ pS, haben.

Für den erfindungsgemäßen Verwendungszweck kommen alle der oben genannten, an sich bekannten Antistatika in Betracht, welche in den betreffenden organischen Entwicklerlösungsmitteln löslich sind und mit diesen oder mit den zu entwickelnden bildmäßig belichteten lichtempfindlichen Aufzeichnungselementen (Flexodruckplatten) keine Reaktionen eingehen oder hier in Reaktionen initiieren.

Beispiele für Antistatika, welche für den erfindungsgemäßen Verwendungszweck gut geeignet sind, sind

(i) die tertiären Amine und Amide der allgemeinen Formel I,

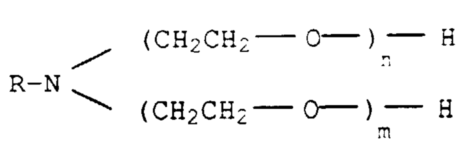

(I)

worin die Indices und die Variablen die folgende Bedeutung haben:

R $C_{12}$- bis $C_{18}$-Alkyl, $C_{18}$-Alkenyl, $C_{12}$- bis $C_{18}$-Alkancarbonyl oder $C_{18}$-Alkencarbonyl,

n eine ganze Zahl von 1 bis 15 und unabhängig hiervon

m eine ganze Zahl von 1 bis 15;

(ii) die quaternären Ammoniumsalze der allgemeinen Formel II,

$$[NR^1R^2R^3R^4]^{\oplus} X^{\ominus} \qquad II$$

worin die Variablen die folgende Bedeutung haben:

$X^{\ominus}$ $Cl^{\ominus}$, $Br^{\ominus}$, $I^{\ominus}$, $R^1$-O-$PO_3H^{\ominus}$, $(R^1\text{-}O)_2PO_2^{\ominus}$, $R^1$-$PO_3^{\ominus}$, $R^1$-$SO_3^{\ominus}$, $R^1$-$COO^{\ominus}$, $CF_3SO_3^{\ominus}$, $R^1$-$OSO_3^{\ominus}$,

$R^1$ $C_1$- bis $C_4$-Alkyl,

$R^2$ und $R^3$ $C_1$- bis $C_{20}$-Alkyl,
-(-$CH_2CH_2$-O-)$_n$-H, worin n eine ganze Zahl von 1 bis 15 bezeichnet und wobei $R^2$ und $R^3$ gleich oder verschieden sein können,

$R^4$ -(-$CH_2CH_2$-O-)$_n$-H, worin n eine ganze Zahl von 1 bis 15 bezeichnet,
$C_{12}$-, $C_{14}$-, $C_{16}$- und $C_{18}$-Alkyl,
3-Azatridecan-1-yl bis 3-Azadocosan-1-yl,
4-Azatridecan-1-yl bis 4-Azadocosan-1-yl,
3-Aza-4-oxo-tridecan-1-yl bis 3-Aza-4-oxo-docosan-1-yl,
4-Aza-5-oxo-tridecan-1-yl bis 4-Aza-5-oxo-docosan-1-yl,
3-Oxa-tridecan-1-yl bis 3-Oxa-docosan-1-yl,
4-Oxa-tridecan-1-yl bis 4-Oxadocosan-1-yl,
2-Hydroxy-4-oxa-tridecan-1-yl bis 2-Hydroxy-4-oxa-docosan-1-yl;

(iii) die primären Etheramine der allgemeinen Formel III

$$R^5\text{-}O\text{-}R^6\text{-}NH_2 \qquad III$$

worin die Variable $R^5$ für einen $C_6$- bis $C_{20}$-Alkylrest und die Variable $R^6$ für einen $C_2$- bis $C_6$-Alkandiylrest steht;

und
(iv) die Alkali-, Erdalkali- und Übergangsmetallsalze von Aminocarbonsäuren.

Beispiele vorteilhafter Reste R in den tertiären Aminen und Amiden der allgemeinen Formel I sind Dodecyl(=Lauryl)-, Tridecyl-, Tetradecyl(=Myristyl)-, Pentadecyl-, Hexadecyl(=Palmityl)-, Heptadecyl-, Octadecyl(=Stearyl)-, Oleyl-, 1-Oxo-dodecan-1-yl-, 1-Oxo-tridecan-1-yl-, 1-Oxo-tridecan-1-yl-, 1-Oxo-tetradecan-1-yl, 1-Oxo-pentadecan-1-yl, 1-Oxo-hexadecan-1-yl-, 1-Oxo-heptadecan-1-yl-, 1-Oxo-octadecan-1-yl- und 1-Oxo-octadec-9-en-1-yl-Reste.

Die erfindungsgemäß zu verwendenden vorteilhaften Amine und Amide I werden im allgemeinen, durch Ethoxylierung von Aminen, wie Dodecyl(=Lauryl)-, Tridecyl-, Tetradecyl(=Myristyl)-, Pentadecyl-, Hexadecyl(=Palmityl)-, Octadecyl(=Stearyl)- oder Oleylamin oder deren Gemische oder durch Ethoxylierung von Amiden, wie Laurinsäure-, Tridecancarbonsäure-, Myristinsäure-, Pentadecancarbonsäure-, Palmitinsäure-, Heptadecancarbonsäure-, Stearinsäure- oder Ölsäureamid gebildet. Hierbei werden jeweils zwei 2-Hydroxyethylgruppen mit einem Stickstoffatom verknüpft, was der Bedingung n und m = 1 der allgemeinen Formel I entspricht. Es werden indes hierbei auch ein oder zwei längerkettige $\omega$-Hydroxy-poly(ethylenoxid)-$\alpha$-yl-Reste mit einem Stickstoffatom verknüpft, wobei diese Reste unabhängig voneinander bis zu 15, vorzugsweise 5 bis 12 und insbesondere 8 bis 11 Ethylenoxideinheiten aufweisen. Wird hierbei nur ein langkettiger Rest mit dem Stickstoffatom verknüpft, so handelt es sich bei dem anderen Rest um eine 2-Hydroxyethylgruppe. Bevorzugt wird die Verknüpfung zweier 2-Hydroxyethylgruppen mit einem Stickstoffatom.

Beispiele besonders vorteilhafter tertiärer Amine und Amide der allgemeinen Formel I sind demnach N,N-Bis-(2-hydroxyethyl)-N-dodecyl(=lauryl)-, -N-tridecyl-, -N-tetradecyl(=myristyl)-, -N-pentadecyl-, -N-hexadecyl(=palmityl)-, -N-heptadecyl-, -N-stearyl- und -N-oleylamin und deren Gemische; N,N-Bis-(2-hydroxyethyl)-laurinsäure-, -tridecancarbonsäure-, -myristinsäure-, -pentadecancarbonsäure-, -palmitinsäure-, -heptadecancarbonsäure-, -stearinsäure- und -ölsäureamid und deren Gemische; sowie alle jene Gemische, die diese Amine und Amide nebeneinander enthalten.

Beispiele vorteilhafter Reste $R^1$ in den quaternären Ammoniumsalzen der allgemeinen Formel II sind Methyl-,

Ethyl-, n-Propyl-, i-Propyl-, n-Butyl- und i-Butyl-Reste.

Beispiele vorteilhafter Anionen $X^{\ominus}$ in quaternären Ammoniumsalzen der allgemeinen Formel II sind Chlorid, Bromid, Iodid, $R^1$-O-$PO_3H^{\ominus}$, $(R^1\text{-O})_2PO_2^{\ominus}$, $R^1$-$PO_3^{\ominus}$, $R^1$-$SO_3^{\ominus}$, $R^1$-$COO^{\ominus}$, $CF_3SO_3^{\ominus}$ und $R^1$-$OSO_3^{\ominus}$, worin $R^1$ die vorstehend angegebene Bedeutung hat.

Beispiele vorteilhafter Reste $R^2$ und $R^3$ in den quaternären Ammoniumsalzen der allgemeinen Formel II sind Methyl-, Ethyl-, n-Propyl-, i-Propyl-, n-Butyl-, i-Butyl-, n-Pentyl-, n-Hexyl-, n-Heptyl-, n-Octyl-, i-Octyl-, n-Nonyl-, n-Decyl-, i-Decyl-, n-Undecyl-, n-Dodecyl(=Lauryl)-, n-Tridecyl-, n-Tetradecyl(=Myristyl)-, n-Pentadecyl-, n-Hexadecyl(=Palmityl)-, n-Heptadecyl-, Stearyl-, n-Nonadecyl- und n-Eicosanyl-Reste sowie 2-Hydroxyethyl- und ω-Hydroxy-poly(ethylenoxid)-α-yl-Reste mit 2 bis 15, vorzugsweise 5 bis 12 und insbesondere 8 bis 11 Ethylenoxideinheiten in der Kette. Hierbei sind $R^2$ und $R^3$ gleich oder verschieden voneinander.

Beispiele vorteilhafter Reste $R^4$ in den quaternären Ammoniumsalzen der allgemeinen Formel II sind 2-Hydroxyethyl- und ω-Hydroxy-poly(ethylenoxid)-α-yl-Reste mit 2 bis 15, vorzugsweise 5 bis 12 und insbesondere 8 bis 11 Ethylenoxideinheiten in der Kette; Lauryl-, Myristyl-, Palmityl- und Stearyl-Reste; 3-Aza-tridecan-1-yl-, 3-Azatetradecan-1-yl-, 3-Aza-pentadecan-1-yl(=2-Laurylaminoethyl)-, 3-Aza-hexadecan-1-yl-, 3-Aza-heptadecan-1-yl(=2-Myristylaminoethyl)-, 3-Aza-octadecan-1-yl-, 3-Aza-nonadecan-1-yl(=2-Palmitylaminoethyl)-, 3-Aza-eicosan-1-yl-, 3-Aza-heneicosan-1-yl(=2-Stearylaminoethyl)- und 3-Aza-docosan-1-yl-Reste; 4-Aza-tridecan-1-yl-, 4-Aza-tetradecan-1-yl-, 4-Azapentadecan-1-yl-, 4-Aza-hexadecan-1-yl(=3-Laurylaminopropyl)-, 4-Aza-heptadecan-1-yl-, 4-Aza-octadecan-1-yl(=3-Myristylaminopropyl)-, 4-Aza-nonadecan-1-yl-, 4-Aza-eicosan-1-yl(=3-Palmitylaminopropyl)-, 4-Aza-heneicosan-1-yl- und 4-Aza-docosan-1-yl- bzw. 3-stearylaminopropyl-Reste; 3-Aza-4-oxo-tridecan-1-yl-, 3-Aza-4-oxo-tetradecan-1-yl-, 3-Aza-4-oxo-pentadecan-1-yl(=2-Laurylamidoethyl)-, 3-Aza-4-oxo-hexadecan-1-yl-, 3-Aza-4-oxo-heptadecan-1-yl(=2-Myristylamidoethyl)-, 3-Aza-4-oxo-octadecan-1-yl-, 3-Aza-4-oxo-nonadecan-1-yl-(=2-Palmitylamidoethyl)-, 3-Aza-4-oxo-eicosan-1-yl-, 3-Aza-4-oxo-heneicosan-1-yl(=2-Stearylamidoethyl)- und 3-Aza-4-oxo-docosan-1-yl-Reste; 4-Aza-5-oxo-tridecan-1-yl-, 4-Aza-5-oxo-tetradecan-1-yl-, 4-Aza-5-oxo-pentadecan-1-yl-, 4-Aza-5-oxo-hexadecan-1-yl(=3-Laurylamidopropyl)-, 4-Aza-5-oxo-heptadecan-1-yl-, 4-Aza-5-oxo-octadecan-1-yl(=3-Myristylamidopropyl)-, 4-Aza-5-oxo-nonadecan-1-yl-, 4-Aza-5-oxo-eicosan-1-yl-(=3-Palmitylamidopropyl)-, 4-Aza-5-oxo-heneicosan-1-yl- und 4-Aza-5-oxo-docosan-1-yl- bzw. 3-Stearylamidopropyl-Reste; 3-Oxa-tridecan-1-yl-, 3-Oxa-tetradecan-1-yl-, 3-Oxa-pentadecan-1-yl(=2-Lauryloxiethyl)-, 3-Oxa-hexadecan-1-yl-, 3-Oxa-heptadecan-1-yl(=2-Myristyloxiethyl)-, 3-Oxa-octadecan-1-yl-, 3-Oxa-nonadecan-1-yl(=2-Palmityloxiethyl)-, 3-Oxa-eicosan-1-yl-, 3-Oxa-heneicosan-1-yl(=2-Stearyloxiethyl)- und 3-Oxa-docosan-1-yl-Reste; 4-Oxa-tridecan-1-yl-, 4-Oxa-tetradecan-1-yl-, 4-Oxa-pentadecan-1-yl-, 4-Oxa-hexadecan-1-yl(=3-Lauryloxipropyl)-, 4-Oxa-heptadecan-1-yl-, 4-Oxa-octadecan-1-yl (=3-Myristyloxipropyl)-, 4-Oxa-nonadecan-1-yl-, 4-Oxa-eicosan-1-yl(=3-Palmityloxipropyl)-, 4-Oxa-heneicosan-1-yl- und 4-Oxa-docosan-1-yl- bzw. 3-Stearyloxipropyl-Reste; sowie 2-Hydroxy-4-oxa-tridecan-1-yl-, 2-Hydroxy-4-oxa-tetradecan-1-yl-, 2-Hydroxy-4-oxa-pentadecan-1-yl-, 2-Hydroxy-4-oxa-hexadecan-1-yl(=3-Lauryloxi-2-hydroxypropyl)-, 2-Hydroxy-4-oxaheptadecan-1-yl-, 2-Hydroxy-4-oxa-octadecan-1-yl(=3-Myristyloxi-2-hydroxypropyl)-, 2-Hydroxy-4-oxa-nonadecan-1-yl-, 2-Hydroxy-4-oxa-eicosan-1-yl(=3-Palmityloxi-2-hydroxypropyl)-, 2-Hydroxy-4-oxa-heneicosan-1-yl- und 2-Hydroxy-4-oxa-docosan-1-yl- bzw. 3-Stearyloxi-2-hydroxypropyl-Reste.

Beispiele für Reste $R^1$, die mit besonderem Vorteil in den quaternären Ammoniumsalzen der allgemeinen Formel II verwendet werden, sind Methyl- und Ethylreste.

Beispiele für Reste $R^2$ und $R^3$, die mit besonderem Vorteil in den quaternären Ammoniumsalzen der allgemeinen Formel II verwendet werden, sind Methyl-, Ethyl-, Lauryl-, Myristyl-, Palmityl-, Stearyl- und 2-Hydroxyethyl-Reste.

Beispiele für Reste $R^4$, die mit besonderem Vorteil in den quaternären Ammoniumsalzen der allgemeinen Formel II verwendet werden, sind 2-Hydroxyethyl-, Lauryl-, Myristyl-, Palmityl-, Stearyl-, 2-Laurylaminoethyl-, 2-Myristylaminoethyl-, 2-Palmitylaminoethyl-, 2-Stearylaminoethyl-, 3-Laurylaminopropyl-, 3-Myristylaminopropyl-, 3-Stearylaminopropyl-, 2-Laurylamidoethyl-, 2-Myristylamidoethyl-, 2-Palmitylamidoethyl-, 2-Stearylamidoethyl-, 3-Laurylamidopropyl-, 3-Myristylamidopropyl-, 3-Palmitylamidopropyl-, 3-Stearylamidopropyl-, 2-Lauryloxiethyl-, 2-Myristyloxiethyl-, 2-Palmityloxiethyl-, 2-Stearyloxiethyl-, 3-Lauryloxipropyl-, 3-Myristyloxipropyl-, 3-Stearyloxipropyl-, 3-Lauryloxi-2-hydroxypropyl-, 3-Myristyloxi-2-hydroxypropyl-, 3-Palmityloxi-2-hydroxypropyl- und 3-Stearyloxi-2-hydroxypropyl-Reste.

Das Anion, welches mit besonderem Vorteil in den quaternären Ammoniumsalzen der allgemeinen Formel II verwendet wird, ist Ethylsulfat.

Beispiele für besonders vorteilhafte erfindungsgemäß anzuwendende quaternäre Ammoniumsalze der allgemeinen Formel II sind:

N-Methyl-N,N-bis-(2-hydroxyethyl)-N-lauryl-, -N-myristyl-, -N-palmityl- und -N-stearyl-ammonium-ethylsulfat;

N-Methyl-N,N-bis-(2-hydroxyethyl)-N-(2-laurylaminoethyl)-, -N-(2-myristylaminoethyl)-, -N-(2-palmitylaminoethyl)- und -N-(2-stearylaminoethyl)-ammonium-ethylsulfat;

N,N-Dimethyl-N-(2-hydroxyethyl)-N-(3-laurylaminopropyl)-, -N-(3-myristylaminopropyl)-, -N-(3-palmitylaminopropyl)- und -N-(3-stearylaminopropyl)-ammonium-ethylsulfat;

N,N,N-Trimethyl-N-(2-hydroxyethyl)-ammonium-ethylsulfat;

N,N-Dimethyl-N-(2-hydroxyethyl)-N-(2-laurylamidoethyl)-, -N-(2-myristylamidoethyl)-, -N-(2-palmitylamidoethyl)- und -N-(2-stearylamidoethyl)-ammonium-ethylsulfat;

N,N-Dimethyl-N-(2-hydroxyethyl)-N-(3-laurylamidopropyl)-, -N-(3-myristylamidopropyl)-, -N-(3-palmitylamidopropyl)- und -N-(3-stearylamidopropyl)-ammonium-ethylsulfat;

N-Methyl-N,N-bis-(2-hydroxyethyl)-N-(2-lauryloxiethyl)-, -N-(2-myristyloxiethyl)-, -N-(2-palmityloxiethyl)- und -N-(2-stearyloxiethyl)-ammonium-ethylsulfat;

N,N-Dimethyl-N-(2-hydroxyethyl)-N-(3-lauryloxipropyl)-, -N-(3-myristyloxipropyl)-, -N-(3-palmityloxipropyl)- und -N-(3-stearyloxipropyl)-ammonium-ethylsulfat;

N-Methyl-N,N-bis-(2-hydroxyethyl)-N-(3-lauryloxi-2-hydroxypropyl)-, -N-(3-myristyloxi-2-hydroxypropyl)-, -N-(3-palmityloxi-2-hydroxypropyl)- und -N-(3-stearyloxi-2-hydroxypropyl)-ammonium-ethylsulfat;
und

N,N-Dimethyl-N-(2-hydroxyethyl)-N-(3-lauryloxi-2-hydroxypropyl)-, -N-(3-myristyloxi-2-hydroxypropyl)-, -N-(3-palmityloxi-2-hydroxypropyl)- und -N-(3-stearyloxi-2-hydroxypropyl)-ammonium-ethylsulfat.

Die quaternären Ammoniumsalze der allgemeinen Formel II werden einzeln oder als Gemisch aus mehreren der Ammoniumsalze angewendet. Sie werden auch als Gemische mit den tertiären Aminen und Amiden der allgemeinen Formel I verwendet. Von besonderem Vorteil ist es indes, die tertiären Amine und Amide I oder die quaternären Ammoniumsalze II getrennt anzuwenden. Von ganz besonderem Vorteil ist hierbei, Gemische aus tertiären Aminen und Amiden I oder Gemische aus quaternären Ammoniumsalzen II zu verwenden. Solche Gemische sind bekannt und im Handel erhältlich. Beispielsweise werden von der Firma Georg M. Langer und Co. Gemische und Lösungen von quaternären Ammoniumsalzen der allgemeinen Formel II unter den Markennamen Catafor® CA 100, CA 80 (Lösung in Butanol), BCA 100 oder BCA 80 (Lösung in Butanol) sowie tertiäre Amine und Amide der allgemeinen Formel I unter dem Markennamen Catafor® 06 vertrieben. Diese Amine und Amide I finden sich auch unter Warenzeichen, wie Armostat® 600 der Firma Akzo oder Antistatikum® Hoechst VP FA 14 der Firma Hoechst im Markt.

Beispiele vorteilhafter Reste $R^5$ in den primären Etheraminen der allgemeinen Formel III sind die vorstehend bei den Reste $R^2$ oder $R^3$ genannten $C_6$- bis $C_{20}$-Alkylreste.

Beispiele vorteilhafter Reste $R^6$ in den primären Etheraminen der allgemeinen Formel III sind Ethan-1,2-diyl-, Propan-1,3-diyl- und Butan-1,4-diyl-Reste.

Beispiele für besonders vorteilhafte erfindungsgemäß anzuwendende primäre Etheramine der allgemeinen Formel III sind 3-Hexyloxi-prop-1-yl-amin und 3-Isodecyloxi-prop-1-yl-amin, von denen ersteres ganz besonders vorteilhaft ist.

Beispiele vorteilhafter Alkali-, Erdalkali- und Übergangsmetallsalze von Aminocarbonsäuren, sind die Alkali-, Erdalkali- oder Übergangsmetallsalze der Anthranilsäure und des Alanins.

Beispiele ganz besonders vorteilhafter Anthranilsäure- und Alaninsalze sind Chromanthranilat und Calciumsemialanat, welche einzeln oder im Gemisch angewandt werden können. Hierbei erweisen sich die technischen Gemische dieser beiden Salze, welche noch zusätzlich ein Antioxidans enthalten und welche schon in einem Paraffingemisch gelöst vorliegen, als ganz besonders vorteilhaft. Diese technischen Gemische sind allgemein bekannt und im Handel unter dem Handelsnamen oder Warenzeichen ASA 3 der Firma Shell oder Kerostat® 50.09 der Firma BASF erhältlich.

Bei einer besonders vorteilhaften Variante des erfindungsgemäßen Verfahrens enthält das organische Entwicklerlösungsmittel Benzylalkohol und/oder mindestens einen in seinem Siedepunkt oder Siedebereich dem Siedebereich des organischen Entwicklerlösungsmittels angepaßten, nahezu geruchlosen gesättigten Alkohol mit verzweigtem Alkylrest im Molekül. Vorteilhafterweise ist dieser Alkohol in dem organischen Entwicklerlösungsmittel in einer Menge von 5 bis 50, vorteilhafterweise 5 bis 30, insbesondere 10 bis 25 Vol.% enthalten. Beispiele gut geeigneter Alkohle sind neben Benzylalkohol Isoheptanol, Isooctanol, Isononanol, 3,5,5-Trimethylhexanol, 2-Ethylhexanol und die technischen Gemische verzweigter Alkohole, welche von der Firma Exxon unter dem Handelsnamen oder Warenzeichen Exxal 7, 8 und 9 vertrieben werden. Diese Alkohole sieden oberhalb 150°C und haben bei Raumtemperatur nur einen geringen Dampfdruck. Im Vergleich zu n-Butanol oder n-Pentanol ist ihr Geruch deutlich schwächer.

Als organische Entwicklerlösungsmittel kommen für das erfindungsgemäße Verfahren all diejenigen organischen Lösungsmittel und Lösungsmittelgemische in Betracht, welche die nicht belichteten und daher nicht photopolymerisierten Bereiche der bildmäßig belichteten Aufzeichnungsschichten (B) lichtempfindlicher Aufzeichnungselemente zu

lösen oder anzuquellen vermögen. Hiervon sind diejenigen besonders gut geeignet und werden ausschließlich verwendet, welche nichtbrennbar, schwerbrennbar und/oder hochsiedend sind. Hierbei bedeutet "nichtbrennbar", daß das betreffende organische Entwickerlösungsmittel für sich selbst gesehen unter dem Sauerstoffpartialdruck der Luft die Verbrennung nicht aufrecht erhält. "Schwerbrennbar" bedeutet, daß das organische Entwicklerlösungsmittel für sich selbst gesehen einen Flammpunkt nach DIN 51 755 oder DIN 51 758 oberhalb 45, vorzugsweise 50 und insbesondere 60°C hat. "Hochsiedend" bedeutet, daß das betreffende organische Entwicklerlösungsmittel einen Siedepunkt oder Siedebereich oberhalb 120, vorzugsweise 150 und insbesondere 160°C hat.

Beispiele ganz besonders gut geeigneter organischer Entwicklerlösungsmittel sind chlorierte Kohlenwasserstoffe, gesättigte und/oder ungesättigte cyclische Kohlenwasserstoffe, gesättigte und/oder ungesättigte acyclische Kohlenwasserstoffe, Petroleumdestillate, entaromatisierte Erdölfraktionen, Essigsäure-alkyl und -alkoxialkylester, Glykolsäurealkyl- und alkoxialkylester, Alkyl- und Alkoxialkylester von höheren gesättigten aliphatischen Carbonsäuren, welche gegebenenfalls alkoxisubstituiert sind, Dialkylenglykoldialkylether und/oder deren Gemische, sofern sie weitgehend geruchsfrei, nichtbrennbar oder schwerbrennbar und/oder hochsiedend sind. Hiervon werden die entaromatisierten Erdölfraktionen, welche dieses Eigenschaftsprofil aufweisen, bevorzugt verwendet, weil sie besonders vorteilhaft sind.

Ganz besonders vorteilhafte entaromatisierte Erdölfraktionen sind hydrierte Erdölfraktionen. Beispiele erfindungsgemäß zu verwendender hydrierter Erdölfraktionen sind Testbenzine, welche einen Siedebereich von 150 bis 220°C, einen Flammpunkt von über 45°C, einen Aromatengehalt von kleiner 1 %, einen Gehalt an naphthenischen Kohlenwasserstoffen von 35 % und einen Gehalt an Paraffinen von größer 64 % aufweisen; synthetische Isoparaffine, welche einen Siedebereich von 180 bis 220°C, einen Flammpunkt von über 65°C und einen Gehalt an Paraffinen von größer 99 % aufweisen; Testbenzine, welche einen Siedebereich von 170 bis 260°C, einen Flammpunkt oberhalb 60°C, einen Aromatengehalt von 13 %, einen Gehalt an naphthenischen Kohlenwasserstoffen von 10 % und einen Paraffingehalt von 77 % aufweisen; n-Paraffin-Fraktionen, welche einen Siedebereich von 180 bis 230°C, einen Flammpunkt oberhalb 55°C, einen Aromatengehalt kleiner 0,1 % und einen Paraffingehalt von größer 99,9 % aufweisen; hydrierte Mineralöle, welche einen Siedebereich von 220 bis 260°C, einen Flammpunkt von 90°C und höher, einen Aromatengehalt von 3 %, einen Gehalt an naphthenischen Kohlenwasserstoffen von 31 % und einen Paraffingehalt von 66 % aufweisen. Von diesen sind diejenigen hydrierten Erdölfraktionen bevorzugt, welche einen Siedebereich zwischen 150 und 220°C und einen Aromatengehalt von kleiner 1 % haben.

Diese hydrierten Erdölfraktionen sind übliche und bekannte Handelsprodukte und werden, wie eingangs angegeben, von den Firmen Exxon, Shell und Hydrocarbures vertrieben.

Außerdem kommen noch Reinsubstanzen wie beispielsweise Decahydronaphthalin in Betracht. Indes werden für den erfindungsgemäßen Verwendungszweck die hydrierten Erdölfraktionen der Exxol D- und Shellsol D-Reihe besonders bevorzugt verwendet.

Methodisch gesehen bietet das erfindungsgemäße Verfahren keine Besonderheiten, d.h. man entwickelt die in üblicher und bekannter Weise bildmäßig belichtete photopolymerisierbare Aufzeichnungsschicht (B) eines lichtempfindlichen Aufzeichnungselemts durch Auswaschen der nichtbelichteten und daher nicht photopolymerisierten Bereiche mit den vorstehend beschriebenen erfindungsgemäß anzuwendenden Entwicklerlösungsmitteln in den bekannten Sprüh-, Bürsten- und Reibewaschern bei Temperaturen von 20 bis 60°C, insbesondere 20 bis 35°C. Bereits hierbei zeigt sich ein nicht zu unterschätzender Vorteil des erfindungsgemäßen Verfahrens, welche darin liegt, daß keine explosionsgeschützten Wascher verwendet werden müssen. Außerdem brauchen die Wascher keine Vorrichtung zur Sicherheitsabschaltung mehr, welche den Wascher abschaltet, wenn die Betriebstemperatur 40°C überschreitet. Im Gegenteil können bei dem erfindungsgemäßen Verfahren höhere Betriebstemperaturen in den Waschern angewandt werden. Ein weiterer nicht zu unterschätzender Vorteil liegt darin, daß die Auswaschbedingungen verschärft werden können, ohne daß hierbei eine gefährliche elektrostatische Aufladung des erfindungsgemäß zu verwendenden organischen Entwicklerlösungsmittels zu befürchten wäre. So können beispielsweise der Sprühdruck, die Bürstendrehzahl oder die Reibung in den Waschern über das bislang bekannte Maß hinaus erhöht werden, wenn es für das betreffende erfindungsgemäße Verfahren vorteilhaft ist. Dadurch ermöglicht das erfindungsgemäße Verfahren die raschere Entwicklung bildmäßig belichteter Aufzeichnungsschichten (B), als es bislang möglich war, weswegen die optimalen Auswaschzeiten des erfindungsgemäßen Verfahrens deutlich kürzer sind als die der bekannten Verfahrensweisen. Dabei können - im Gegensatz zu den bislang bekannten Verfahrensweisen - die verschärften Betriebsbedingungen in den Waschern durch Variation des Lösevermögens des erfindungsgemäßen organischen Entwicklerlösungsmittels so ausgeglichen und optimiert werden, daß es beim Überschreiten der optimalen Auswaschzeiten nicht zur sogenannten Überwaschung, d.h. dem Herausbrechen von Material aus der Reliefschicht der photopolymeren flexographischen Reliefdruckplatten durch mechanische Einwirkung (Kantenausbruch) kommt. Unter optimaler Auswaschzeit ist dabei die Zeit zu verstehen, in welcher man beim Auswaschen gerade die jeweils erwünschte oder die maximale Relieftiefe erreicht. Wegen der nun möglichen einfacheren gegenseitigen Abstimmung der Betriebsbedingungen des Waschers und des Lösevermögens des organischen Entwicklerlösungsmittels wird die optimale Auswaschzeit einer vorgegebenen bildmäßig belichteten Aufzeichnungsschicht (B) im Vergleich zum Stand der Technik noch weiter verkürzt. Da bei dem erfindungsgemäßen Verfahren vor allem weitgehend geruchsfreie organische Entwicklerlösungsmittel verwendet

werden, können die Betriebstemperaturen der Wascher im Vergleich zu den bekannten Verfahrensweisen deutlich erhöht werden, ohne daß es hierbei zu Geruchsbelästigungen für das Bedienungspersonal im reprographischen Betrieb kommt. Ein zusätzlicher überraschender Vorteil des erfindungsgemäßen Verfahrens ist, daß es - selbst nach längerem Betrieb - in den Waschern und auf den hergestellten photopolymeren flexographischen Reliefdruckplatten nicht zu Ablagerungen kommt.

Darüber hinaus können die verbrauchten erfindungsgemäß zu verwendenden organischen Entwicklerlösungsmittel, insbesondere diejenigen auf der Basis hydrierter Erdölfraktionen, besonders einfach durch Vakuumdestillation wiederaufgearbeitet und erneut für den erfindungsgemäßen Anwendungszweck verwendet werden. Enthalten diese hydrierten Erdölfraktionen synthetische Etheramine der allgemeinen Formel III eines nicht zu hohen Molekulargewichts, beispielsweise 3-Hexyloxiprop-1-yl-amin, als Antistatika, ist die Zusammensetzung des Destillats gegenüber der ursprünglichen Zusammensetzung des organischen Entwicklerlösungsmittels nicht verändert, so daß eine Nachdosierung der Antistatika nicht erforderlich ist.

Die mit Hilfe des erfindungsgemäßen Verfahrens hergestellten photopolymeren flexographischen Reliefdruckplatten bzw. deren Reliefschichten haben eine stärker ausgeprägte Tiefe und einen sehr guten Flankenaufbau, wobei die Oberfläche dieser Reliefschichten überraschenderweise deutlich glatter und gleichmäßiger ist als die Oberfläche von Reliefschichten, welche nach den bekannten Verfahrensweisen hergestellt worden sind. Insbesondere weisen die nach dem erfindungsgemäßen Verfahren hergestellten Reliefschichten keine Orangenhaut mehr auf. Des weiteren ist die Quellung der Bildelemente in den Reliefschichten deutlich geringer als bei der Verwendung üblicher Entwicklerlösungsmittel, und die in erfindungsgemäßer Verfahrensweise hergestellten photopolymeren flexographischen Reliefdruckplatten haben eine deutlich geringere Neigung zur Rißbildung.

Bei der Durchführung des erfindungsgemäßen Verfahrens kann dem eigentlichen Entwicklungsschritt das Wegwaschen der gegebenenfalls vorhandenen alkohol- oder wasserlöslichen Deckschicht (C) vorausgehen, was bekanntermaßen als "prewipe" bezeichnet wird. Dieser "prewipe" wird vor allem bei bildmäßig belichteten lichtempfindlichen Aufzeichnungselementen mit wasserlöslichen Deckschichten (C) durchgeführt.

Bei der Durchführung des erfindungsgemäßen Verfahrens geht dem Entwicklungsschritt und gegebenenfalls dem "prewipe" eine übliche und bekannte bildmäßige Belichtung des lichtempfindlichen Aufzeichnungselements bzw. dessen photopolymerisierbarer Aufzeichnungsschicht (B) mit aktinischem Licht einer Wellenlänge $\lambda$ von 230 bis 450, insbesondere 300 bis 450 nm voraus. Hierfür geeignete Lichtquellen sind z.B. die Strahlung der Sonne, handelsübliche UV-Fluoreszenzröhren, Quecksilbermittel-, -hoch- und -niederdruckstrahler, superaktinische Leuchtstoffröhren, Xenonimpulslampen, mit Metalliodiden dotierte Lampen oder Kohlebogenlampen.

Dem Entwicklungsschritt schließt sich im weiteren Ablauf des erfindungsgemäßen Verfahrens die Trocknung der hieraus resultierenden photopolymeren flexographischen Reliefdruckplatten an. Vorteilhafterweise erfolgt die Trocknung in Trocknergeräten wie beispielsweise Umlufttrockner bei Temperaturen oberhalb der Raumtemperatur, insbesondere oberhalb 40°C. Vorteilhafterweise wird die Trocknung der aus dem erfindungsgemäßen Verfahren resultierenden photopolymeren flexographischen Reliefdruckplatten so lange durchgeführt, bis die Toleranzen in ihren Reliefschichten $\leq 20$, insbesondere $\leq 15$ µm, erreicht haben. Hiernach weisen die in erfindungsgemäßer Verfahrensweise hergestellten photopolymeren flexographischen Reliefdruckplatten auch keinen Langzeitschrumpf mehr auf, was die Grundvoraussetzung für ihre vorzügliche Wiederverwendbarkeit ist.

Vorteilhafterweise werden die Toleranzen der Reliefschichten separat an Volltonflächen des Formats DIN A3 anhand von 40 Meßstellen bestimmt.

Anschließend können die in erfindungsgemäßer Verfahrensweise erhaltenen photopolymeren flexographischen Reliefdruckplatten noch in Halogen enthaltenden oder liefernden Bädern halogeniert, in reduzierenden Bädern nachgewaschen und erneut getrocknet werden. Alternativ oder im Nachgang zu dieser Behandlung können die photopolymeren flexographischen Reliefdruckplatten noch mit aktinischem Licht, insbesondere Licht einer Wellenlänge $\lambda$ von $\leq 250$ nm, vollflächig belichtet werden.

Ein weiterer Vorteil des erfindungsgemäßen Verfahrens ist es, daß es an zahlreichen bekannten, für die Herstellung photopolymerer flexographischer Reliefdruckplatten geeigneten lichtempfindlichen Aufzeichnungselementen oder Flexodruckplatten mit gutem Erfolg ausgeführt werden kann. Solche bekannten lichtempfindlichen Aufzeichnungselemente umfassen

A) einen dimensionsstabilen Träger und

B) mindestens eine photopolymerisierbare lichtempfindliche Aufzeichnungsschicht, welche

$b_1$) mindestens ein elastomeres Polymer als Bindemittel,
$b_2$) mindestens ein photopolymerisierbares Monomeres, welches mit dem polymeren Bindemittel ($b_1$) verträglich ist, und
$b_3$) mindestens einen Photopolymerisationsinitiator enthält,

und werden von der Fachwelt auch etwas ungenau als "Flexodruckplatten" bezeichnet.

Die photopolymerisierbaren Aufzeichnungsschichten (B) dieser Flexodruckplatten können außer den essentiellen Komponenten ($b_1$), ($b_2$) und ($b_3$) noch geeignete Zusätze wie Inhibitoren der thermisch initiierten Polymerisation, Farbstoffe, Pigmente, photochrome Stoffe, Lichthofschutzmittel, Weichmacher, Antioxidantien, Antiozonantien, Mittel zur Verbesserung der Reliefstruktur, Vernetzungshilfsmittel, Flußmittel, Trennmittel, Füllmittel und/oder Verstärkerfüllstoffe in wirksamen Mengen enthalten. Hierbei können die Flexodruckplatten mehrere dieser photopolymerisierbaren Aufzeichnungsschichten (B) übereinanderliegend und haftfest miteinander verbunden enthalten, wobei diese Schichten (B) von stofflich gleicher, in etwa gleicher oder unterschiedlicher Zusammensetzung sein können. Das lichtempfindliche Aufzeichnungselement kann außerdem noch eine der eingangs erwähnten üblichen und bekannten Deckschichten (C) enthalten.

Für das erfindungsgemäße Verfahren ist es weiterhin von großem Vorteil, daß die erfindungsgemäß zu verwendenden organischen Entwicklerlösungsmittel an zahlreichen bekannten photopolymerisierbaren lichtempfindlichen Aufzeichnungsschichten (B) mit Erfolg angewandt werden können.

So ergeben sich beispielsweise kurze Auswaschzeiten bei photopolymerisierbaren lichtempfindlichen Aufzeichnungsschichten (B), welche als Bindemittel ($b_1$) Vinylaromat-Alkadien-Blockmischpolymerisate (Styrol-Isopren-Styrol, Styrol-Butadien-Styrol, Styrol-Isopren-Styrol/Butadien, etc.), Alkadien-Acrylnitril-Copolymerisate (Butadien-Acrylnitril), Fluorkautschuke (Vinylidenchlorid-Hexafluorpropylen-Copolymerisate), Naturkautschuke, Silikonpolymerisate, Polysulfidkautschuke oder Ethylen-Propylen-Dien-Terpolymere enthalten.

Die nach dem erfindungsgemäßen Verfahren hergestellten photopolymeren flexographischen Reliefdruckplatten sind nach dem Aufspannen auf Druckzylinder in hervorragender Weise für den Endlosdruck geeignet. Hierbei erweisen sie sich als ausgesprochen stabil gegenüber den Lösungsmitteln der üblicherweise verwendeten Flexodruckfarben und liefern exzellente Druckerzeugnisse in besonders hoher Auflage. Nach ihrem Gebrauch können sie längere Zeit gelagert und danach wiederverwendet werden, ohne daß eine Veränderung des Druckbildes zu befürchten wäre.

Beispiele und Vergleichsversuche

Beispiele 1 bis 3 und Vergleichsversuche V1 bis V3

Die Herstellung photopolymerer flexographischer Reliefdruckplatten nach dem erfindungsgemäßen Verfahren (Beispiele 1 bis 3) und nach bekannten Verfahren (Vergleichsversuche V1 bis V3)

Allgemeine Versuchsvorschrift:

Für die Beispiele 1 bis 3 und die Vergleichsversuche V1 bis V3 wurden handelsübliche Flexodruckplatten (lichtempfindliche Aufzeichnungselemente) verwendet. Diese enthielten als Trägerfolie (A) eine 125 µm dicke ethylenterephthalatfolie, welche vor dem Aufbringen der photopolymerisierbaren Aufzeichnungsschicht (B) mit einer 0,3 µm dicken Polyurethan-Haftlackschicht beschichtet wurde. Die 2900 µm dicke photopolymerisierbare Aufzeichnungsschicht (B) dieser Flexodruckplatten bestand aus

- 82,616 Gew.-% eines Blockmischpolymerisates XYZ mit einer Viskositätszahl von 164,9 ml/g und einer Gesamtmolmasse von 190.000, bestehend aus, bezogen auf XYZ, 10 Gew.-% Polystyrol als X-Block, 70 Gew.-% Polyisopren einer Glastemperatur $T_g$ von -53°C als Y-Block und 20 Gew.-% Polyisopren mit einem Gehalt von 53 Gew.-% an 3,4-Strukturen und einer Glastemperatur $T_g$ von +10°C als Z-Block

- 5 Gew.-% Weißöl S 5000

- 5 Gew.-% eines Copolymerisats aus α-Methylstyrol (10 Gew.-%) und p-Methylstyrol (90 Gew.-%) mit einem massenmittleren Molekulargewicht $\overline{M}_w$ von $9 \cdot 10^3$

- 3,33 Gew.-% Hexan-1,6-diol-diacrylat

- 1,65 Gew.-% Hexan-1,6-diol-dimethacrylat

- 1,2 Gew.-% Benzildimethylacetal

- 0,198 Gew.-% 2,6-Di-tert.-butyl-p-kresol

- 1,00 Gew.-% des Ozonschutzwachses Antilux® 550 der Firma Rheinchemie und

- 0,006 Gew.-% des Farbstoffs Solvent Black (C.I. 26 150).

Außerdem enthielten die Flexodruckplatten des Beispiels 1 und der Vergleichsversuche V1 und V3 eine 2 µm dicke Deckschicht (C) aus einem hollöslichen Polyamid (Makromelt® 6900 der Firma Henkel), und die Flexodruckplatten der Beispiele 2 und 3 sowie des Vergleichsversuchs V2 enthielten eine wasserlösliche, 3 µm dicke Deckschicht (C) aus dem Polyvinylalkohol Mowiol® 04 M1 der Firma Hoechst. Diese wasserlösliche Deckschicht (C) wurde vor der eigentlichen Entwicklung in einem "prewipe"-Schritt mit Hilfe eines mit reinem Wasser getränkten Schwamms weggewaschen.

Die Flexodruckplatten wurden zunächst während 2 Minuten von ihrer Rückseite her in einem Röhrenbelichter vollflächig vorbelichtet, anschließend durch eine der Deckschicht (C) aufgelegten Testnegativvorlage hindurch während 12 Minuten bildmäßig belichtet und hiernach unter identischen Bedingungen bei 30°C in dem nicht explosionsgeschützten Trommelbürstenwascher nyloflex® F II der Firma BASF in erfindungsgemäßer (Beispiele 1 bis 3) und in üblicher und bekannter Weise (Vergleichsversuch V1 bis V3) entwickelt, wobei die Auswaschzeit bestimmt wurde, welche für das Erreichen einer Relieftiefe von 800 µm jeweils benötigt wurde (= optimale Auswaschzeit).

Die resultierenden photopolymeren flexographischen Reliefdruckplatten wurden anschließend in einem Umluft-Trockenschrank bei 60°C getrocknet. Hierbei wurde die Zeit bestimmt, nach welcher die Reliefschichten ihre Ausgangsschichtdicke (2900 µm) wieder erreicht hatten. Hiernach wurde, falls dies überhaupt noch notwendig war, die Trocknung solange fortgesetzt, bis die Reliefschichten der photopolymeren flexographischen Reliefdruckplatten Toleranzen ≤ 20 µm erreichten oder unterschritten. Die hierfür notwendige Trocknungszeit wurde für jede Flexodruckplatte und für jedes Entwicklerlösungsmittel separat an vollflächig belichteten und ansonsten wie vorstehend beschrieben behandelten Flexodruckplatten des Formats DIN A3 anhand von 40 Meßstellen, an denen die Schichtdicke und die Toleranzen in Abhängigkeit von der Trocknungsdauer gemessen wurden, bestimmt.

Des weiteren wurde sorgfältig auf eine gegebenenfalls auftretende Geruchsbelästigung geachtet und geprüft, ob nach dem Auswaschen noch Reste der alkohollöslichen Deckschicht (C) auf der Oberfläche der photopolymeren flexographischen Reliefdruckplatten des Beispiels 1 und der Vergleichsversuche V1 und V3 vorhanden waren. Außerdem wurde die Wiederaufbereitung der gebrauchten organischen Entwicklerlösungsmittel getestet. Nicht zuletzt wurden die Flammpunkte nach DIN 51 755 für Flammpunkte unterhalb 50°C und nach DIN 51 758 für Flammpunkte oberhalb 50°C der organischen Entwicklerlösungsmittel bestimmt.

Die Tabelle gibt einen Überblick über die angewendeten organischen Entwicklerlösungsmittel und die erhaltenen Versuchsergebnisse.

In der Tabelle haben die Abkürzungen die folgende Bedeutung:

a) Ex = Exxsol D 60 der Firma Esso;
b) TMH = 3,5,5-Trimethylhexanol;
c) P = n-Pentanol;
d) ASA 3 = Gemisch aus Chromanthranilat, Calciumsemianalat und einem Antioxidans, gelöst in einem Paraffingemisch, Antistatikum der Firma Shell;
e) EH = 2-Ethylhexanol;
f) PA-10 = 3-Hexyloxi-prop-1-yl-amin, Antistatikum der Firma Exxon.

Die Versuchsergebnisse untermauern die Vorteilhaftigkeit der erfindungsgemäß zu verwendenden organischen Entwicklerlösungsmittel: wegen ihres hohen Flammpunktes stellten sie kein so großes Sicherheitsrisiko mehr dar als die bislang verwendeten. Wegen ihres nur mäßig intensiven Geruchs belästigten sie das Bedienungspersonal des Trommelbürstenwaschers nicht in dem Ausmaß, wie dies bei einem Teil der üblicherweise verwendeten Entwicklerlösungsmittel der Fall war. Die erfindungsgemäß zu verwendenden Entwicklerlösungsmittel wiesen eine elektrische Leitfähigkeit auf, welche aus sicherheitstechnischer Sicht ausreichte, um sie in den Waschern mit hoher Geschwindigkeit umzupumpen oder mit hohem Sprühdruck zu versprühen. Demgegenüber kam es bei der Verwendung bekannter Entwicklerlösungsmittel unter den exakt vergleichbaren Bedingungen zum Teil zu einer so starken elektrostatischen Aufladung, daß die Versuche vorsichtshalber abgebrochen wurden. Des weiteren konnten die erfindungsgemäß zu verwendenden organischen Entwicklerlösungsmittel in einfacher Weise wiederaufbereitet und für das erfindungsgemäße Verfahren wiederverwendet werden. Die Trocknungszeiten waren kurz und praxisgerecht. Nicht zuletzt wiesen die in erfindungsgemäßer Verfahrensweise hergestellten photopolymeren flexographischen Reliefdruckplatten keine Reste der alkohollöslichen Deckschicht (C) und keine Orangenhaut auf.

Tabelle: Die Herstellung photopolymerer flexographischer Reliefdruckplatten in erfindungsgemäßer (Beispiele 1 bis 3) und nicht erfindungsgemäßer (Vergleichsversuche V1 bis V3) Verfahrensweise

| Beispiele Nr. | | 1 | 2 | 3 |
|---|---|---|---|---|
| Organisches Entwicklerlösungsmittel: | | | | |
| Zusammensetzung: | | | | |
| hydrierte Erdölfraktion | [Gew.-%] | Ex[a)] [80] | Ex[a)] [100] | Ex[a)] [98] |
| Alkohol | [Gew.-%] | TMH[b)] [20] | - | |
| Antistatikum | [ppm] (Gew.-%) | ASA3[d)] [1] | ASA3[d)] [1] | PA-10[f)] (2) |
| Eigenschaften: | | | | |
| Geruch | | sehr gering | geruchlos | sehr gering |
| Flammpunkt nach DIN (Nr.) | °C | 60 (51 758) | 65 (51 758) | 63 (51 758) |
| Leitfähigkeit $\sigma$ | pS | 4500 | 4500 | 120 |
| Versuchsergebnisse: | | | | |
| optimale Auswaschzeit | min | 13 | 10 | 10 |
| Trocknungszeit bis zum Erreichen der Ausgangsschichtdicke | h | 2 | 2 | 2 |
| Trocknungszeit bis zum Erreichen von Toleranzen ≤20 µm | h | 2 | 2 | 2 |
| Oberflächenstrukturen? | | keine | keine | keine |
| Reste der Deckschicht (C) vorhanden? | | nein | - | - |
| Wiederaufarbeitbarkeit des organischen Entwicklerlösungsmittels durch Vakuumdestillation bei 150 mbar und 140°C: | | gut, es muß nur Antistatikum nachdosiert werden | gut, es muß nur Antistatikum nachdosiert werden | sehr gut, es muß kein Antistatikum nachdosiert werden |

Tabelle: Fortsetzung

| Vergleichsversuche | | V1 | V2 | V3 |
|---|---|---|---|---|
| **Organisches Entwicklerlösungsmittel:** | | | | |
| <u>Zusammensetzung:</u> | | | | |
| hydrierte Erdölfraktion | [Gew.-%] | $Ex^{a)}$ [80] | $Ex^{a)}$ [100] | $Ex^{a)}$ [80] |
| Alkohol | [Gew.-%] | $EH^{e)}$ [20] | - | $P^{c)}$ [20] |
| Antistatikum | [ppm] (Gew.-%) | - | - | - |
| <u>Eigenschaften:</u> | | | | |
| Geruch | | gering bis schwach unangenehm | geruchlos | unangenehm reizend |
| Flammpunkt nach DIN (Nr.) | °C | 62 (51 758) | 63 (51 758) | 46 (51 755) |
| Leitfähigkeit σ | pS | 4 | 5 | 610 |
| <u>Versuchsergebnisse:</u> | | | | |
| optimale Auswaschzeit | min | Entwicklung wurde abgebrochen, weil es bei den gewählten Bedingungen zu einer starken elektrostatischen Aufladung kam | wie bei Vergleichsversuchs V2 | 13 |
| Trocknungszeit bis zum Erreichen der Ausgangsschichtdicke | h | | | 2 |
| Trocknungszeit bis zum Erreichen von Toleranzen ≤20 µm | h | | | 2,5 |
| Oberflächenstrukturen? | | | | keine |
| Reste der Deckschicht (C) vorhanden? | | | | nein |
| Wiederaufarbeitbarkeit des organischen Entwicklerlösungsmittels durch Vakuumdestillation bei 150 mbar und 140°C: | | | | schlecht, Alkoholgehalt muß bestimmt werden, $Ex^{a)}$ muß nachdosiert werden |

**Patentansprüche**

1. **1.** Verfahren zur Herstellung einer photopolymeren flexographischen Reliefdruckplatte aus einem lichtempfindlichen Aufzeichnungselement, welches

   A) einen dimensionsstabilen Träger und

   B) mindestens eine photopolymerisierbare Aufzeichnungsschicht mit

   $b_1$) mindestens einem elastomeren Polymeren als Bindemittel,
   $b_2$) mindestens einem photopolymerisierbaren Monomeren, welches mit dem Bindemittel ($b_1$) verträglich ist, und
   $b_3$) mindestens einem Photopolymerisationsinitiator

   enthält, durch

   (1) bildmäßiges Belichten der photopolymerisierbaren Aufzeichnungsschicht (B) mit aktinischem Licht und

   (2) Auswaschen (Entwickeln) der nicht belichteten und daher nicht photopolymerisierten Bereiche der bildmäßig belichteten Aufzeichnungsschicht (B) mit einem organischen Entwicklerlösungsmittel unter Bildung einer Reliefschicht,

   dadurch gekennzeichnet, daß das organische Entwicklerlösungsmittel schwerbrennbar, nichtbrennbar und/oder hochsiedend ist und, bezogen auf seine Gesamtmenge, 1 pphm (1 Teil auf 100.000.00) bis 3 Gew.-% mindestens eines Antistatikums aus der Gruppe

   (i) der tertiären Amine und Amide der allgemeinen Formel I,

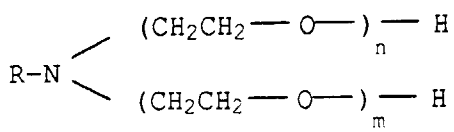

(I)

   worin die Indices und die Variablen die folgende Bedeutung haben:

   R $C_{12}$- bis $C_{18}$-Alkyl, $C_{18}$-Alkenyl, $C_{12}$- bis $C_{18}$-Alkancarbonyl oder $C_{18}$-Alkencarbonyl,

   n eine ganze Zahl von 1 bis 15 und unabhängig hiervon

   m eine ganze Zahl von 1 bis 15;

   (ii) der quaternären Ammoniumsalze der allgemeinen Formel II,

$$[NR^1R^2R^3R^4]^{\oplus} X^{\ominus} \qquad (II)$$

   worin die Variablen die folgende Bedeutung haben:

   $X^{\ominus}$ $Cl^{\ominus}$, $Br^{\ominus}$, $I^{\ominus}$, $R^1$-O-$PO_3H^{\ominus}$, $(R^1\text{-O})_2PO_2^{\ominus}$, $R^1$-$PO_3^{\ominus}$, $R^1$-$SO_3^{\ominus}$, $R^1$-$COO^{\ominus}$, $CF_3SO_3^{\ominus}$, $R^1$-$OSO_3^{\ominus}$,

   $R^1$ $C_1$- bis $C_4$-Alkyl,

   $R^2$ und $R^3$ $C_1$- bis $C_{20}$-Alkyl,
   -(-$CH_2CH_2$-O-$)_n$-H, worin n eine ganze Zahl von 1 bis 15 bezeichnet und wobei $R^2$ und $R^3$ gleich

oder verschieden sein können,

$R^4$ -(-$CH_2CH_2$-O-)$_n$-H, worin n eine ganze Zahl von 1 bis 15 bezeichnet,
$C_{12}$-, $C_{14}$-, $C_{16}$- und $C_{18}$-Alkyl,
3-Azatridecan-1-yl bis 3-Azadocosan-1-yl,
4-Azatridecan-1-yl bis 4-Azadocosan-1-yl,
3-Aza-4-oxo-tridecan-1-yl bis 3-Aza-4-oxo-docosan-1-yl,
4-Aza-5-oxo-tridecan-1-yl bis 4-Aza-5-oxo-docosan-1-yl,
3-Oxa-tridecan-1-yl bis 3-Oxa-docosan-1-yl,
4-Oxa-tridecan-1-yl bis 4-Oxa-docosan-1-yl,
2-Hydroxy-4-oxa-tridecan-1-yl bis 2-Hydroxy-4-oxa-docosan-1-yl;

(iii) der primären Etheramine der allgemeinen Formel III,

$$R^5\text{-O-}R^6\text{-NH}_2 \qquad \text{(III)}$$

worin die Variablen die folgende Bedeutung haben:

$R^5$ $C_6$- bis $C_{20}$-Alkyl und

$R^6$ $C_2$- bis $C_6$-Alkandiyl;

und/oder

(iv) der Alkali-, Erdalkali- und/oder Übergangsmetallsalze von Aminocarbonsäuren enthält.

2. Verfahren nach Anspruch 1, dadurch gekennzeichnet, daß das organische Entwicklerlösungsmittel eine elektrische Leitfähigkeit $\sigma \geq 100$ pS hat.

3. Verfahren nach einem der Ansprüche 1 oder 2, dadurch gekennzeichnet, daß das organische Entwicklerlösungsmittel mindestens eine entaromatisierte Erdölfraktion enthält.

4. Verfahren nach Anspruch 1, dadurch gekennzeichnet, daß als Antistatikum (iv) ein Gemisch aus Chromanthranilat und Calciumsemialanat verwendet wird.

5. Verfahren nach Anspruch 1, dadurch gekennzeichnet, daß als Antistatikum (iii) 3-Hexyloxi-prop-1-yl-amin verwendet wird.

6. Verfahren nach einem der Ansprüche 1 bis 5, dadurch gekennzeichnet, daß das organische Entwicklerlösungsmittel ein lösliches Antioxidans in wirksamen Mengen enthält.

7. Verfahren nach einem der Ansprüche 1 bis 6, dadurch gekennzeichnet, daß das organische Entwicklerlösungsmittel mindestens einen in seinem Siedepunkt oder Siedebereich dem Siedebereich des organischen Entwicklerlösungsmittels angepaßten, nahezu geruchlosen gesättigten Alkohol mit verzweigtem Alkylrest im Molekül und/oder Benzylalkohol enthält.

8. Verfahren nach Anspruch 7, dadurch gekennzeichnet, daß der Alkohol in dem organischen Entwicklerlösungsmittel in einer Menge von 5 bis 50 Vol.-% enthalten ist.

9. Verfahren nach Anspruch 7 oder 8, dadurch gekennzeichnet, daß als gesättigter Alkohol mit einem verzweigten Alkylrest im Molekül Isoheptanol, Isooctanol, Isononanol, 3,5,5-Trimethylhexanol, 2-Ethyl-hexanol und/oder technische Gemische gesättigter Alkohole mit verzweigtem Alkylrest im Molekül verwendet werden.

## Claims

**1.** A process for the production of a photopolymeric flexographic relief printing plate from a photosensitive recording element which contains

A) a dimensionally stable substrate and
B) at least one photopolymerizable recording layer having

$b_1$) at least one elastomeric polymer as a binder,
$b_2$) at least one photopolymerizable monomer which is compatible with the binder ($b_1$) and
$b_3$) at least one photopolymerization initiator,

by

(1) imagewise exposure of the photopolymerizable recording layer (B) to actinic light and
(2) washout (development) of the unexposed and therefore nonphotopolymerized parts of the imagewise exposed recording layer (B) with an organic developer with formation of a relief layer,

wherein the organic developer is poorly flammable, nonflammable and/or high boiling and contains from 1 pphm (1 part per 100,000,000) to 3% by weight, based on its total amount, of at least one antistatic agent from the group consisting of

(i) the tertiary amines and amides of the formula I

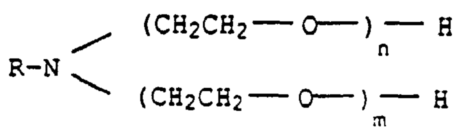

(I)

where R is $C_{12}$-$C_{18}$-alkyl, $C_{18}$-alkenyl, $C_{12}$-$C_{18}$-alkanecarbonyl or $C_{18}$-alkenecarbonyl and n and m independently of one another are each an integer of from 1 to 15;
(ii) the quarternary ammonium salts of the formula II

$$[NR^1R^2R^3R^4]^{\oplus} X^{\ominus} \quad (II)$$

where $X^{\ominus}$ is $Cl^{\ominus}$, $Br^{\ominus}$, $I^{\ominus}$, $R^1$-O-$PO_3H^{\ominus}$, $(R^1$-$O)_2PO_2^{\ominus}$, $R^1$-$PO_3^{\ominus}$, $R^1$-$SO_3^{\ominus}$, $R^1$-$COO^{\ominus}$, $CF_3SO_3^{\ominus}$ or $R^1$-$OSO_3^{\ominus}$, $R^1$ is $C_1$-$C_4$-alkyl, $R^2$ and $R^3$ are each $C_1$-$C_{20}$-alkyl or $-(-CH_2CH_2-O-)_n-H$, where n is an integer from 1 to 15 and $R^2$ and $R^3$ may be identical or different, and $R^4$ is $-(-CH_2CH_2-O-)_n-H$, where n is an integer from 1 to 15, $C_{12}$-, $C_{14}$-, $C_{16}$- or $C_{18}$-alkyl, 3-azatridecan-1-yl to 3-azadocosan-1-yl, 4-azatridecan-1-yl to 4-azadocosan-1-yl, 3-aza-4-oxotridecan-1-yl to 3-aza-4-oxodocosan-1-yl, 4-aza-5-oxotridecan-1-yl to 4-aza-5-oxodocosan-1-yl, 3-oxatridecan-1-yl to 3-oxadocosan-1-yl, 4-oxatridecan-1-yl to 4-oxadocosan-1-yl or 2-hydroxy-4-oxatridecan-1-yl to 2-hydroxy-4-oxadocosan-1-yl;
(iii) the primary ether amines of the formula III

$$R^5\text{-O-}R^6\text{-}NH_2 \quad (III)$$

where $R^5$ is $C_6$-$C_{20}$-alkyl and $R^6$ is $C_2$-$C_6$-alkanediyl;

and/or
(iv) the alkali metal, alkaline earth metal and/or transition metal salts of aminocarboxylic acids.

**2.** A process as claimed in claim 1, wherein the organic developer has an electrical conductivity $\sigma$ of $\geq$ 100 pS.

**3.** A process as claimed in claim 1 or 2, wherein the organic developer contains at least one mineral oil fraction from which aromatics have been removed.

**4.** A process as claimed in claim 1, wherein a mixture of chromium anthranilate and calcium semialanate is used as antistatic agent (iv).

**5.** A process as claimed in claim 1, wherein 3-hexyloxyprop-1-ylamine is used as antistatic agent (iii).

**6.** A process as claimed in claim 1 or 2 or 3 or 4 or 5, wherein the organic developer contains an effective amount of soluble antioxidant.

**7.** A process as claimed in claim 1 or 2 or 3 or 4 or 5 or 6, wherein the organic developer contains at least one virtually odorless saturated alcohol, whose boiling point or boiling range is matched with the boiling range of the organic developer and which has a branched alkyl radical in the molecule, and/or benzyl alcohol.

**8.** A process as claimed in claim 7, wherein the alcohol is present in the organic developer in an amount of from 5 to 50% by volume.

**9.** A process as claimed in claim 7 or 8, wherein isoheptanol, isooctanol, isononanol, 3,5,5-trimethylhexanol, 2-ethylhexanol and/or an industrial mixture of saturated alcohols having a branched alkyl radical in the molecule are used as the saturated alcohol having a branched alkyl radical in the molecule.

**Revendications**

**1.** Procédé de préparation d'une plaque photopolymère d'impression flexographique en relief à partir d'un élément d'enregistrement photosensible qui contient

A) un support à dimensions stables et
B) au moins une couche d'enregistrement photopolymérisable comprenant

b1) au moins un polymère élastomère qui sert de liant,
b2) au moins un monomère photopolymérisable compatible avec le liant b1) et
b3) au moins un initiateur de la photopolymérisation,

par

(1) exposition de la couche d'enregistrement photopolymérisable (B) à la lumière actinique avec formation d'une image et

(2) lavage (développement) des régions non exposées et par conséquent non photopolymérisées de la couche d'enregistrement (B) exposée avec formation d'une image à l'aide d'un solvant révélateur organique, avec formation d'une couche en relief,

caractérisé par le fait que le solvant révélateur organique est difficilement inflammable, ininflammable et/ou à haut point d'ébullition et contient, sur son poids total, en proportions allant de 1 partie pour 100 000 000 à 3 % en poids, au moins un agent antistatique du groupe formé par

i) les amines et amides tertiaires de formule générale I

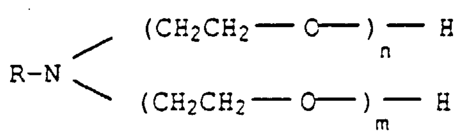

(I)

dans laquelle les indices et les symboles ont les significaitons suivantes :

R : un groupe alkyle en C12-C18, alcényle en C18, alcanecarbonyle en C12-C18 ou alcènecarbonyle en C18,

n est un nombre allant de 1 à 15 et, indépendamment,

m est un nombre entier allant de 1 à 15 ;

ii) les sels d'ammonium quaternaire de formule générale II

$$[NR^1R^2R^3R^4]^{\oplus} X^{\ominus} \qquad (II)$$

dans laquelle les symboles ont les significations suivantes :

$X^{\ominus}$ : $Cl^{\ominus}$, $Br^{\ominus}$, $I^{\ominus}$, $R^1$-O-$PO_3H^{\ominus}$, $(R^1\text{-}O)_2PO_2^{\ominus}$, $R^1$-$PO_3^{\ominus}$, $R^1$-$SO_3^{\ominus}$, $R^1$-$COO^{\ominus}$, $CF_3SO_3^{\ominus}$, $R^1$-$OSO_3^{\ominus}$,

$R^1$ : alkyle en C1-C4,

$R^2$ et $R^3$ : alkyle en C1-C20,
-(-$CH_2CH_2$-O-$)_n$-H, n étant un nombre entier qui va de 1 à 15 et $R^2$ et $R^3$ pouvant avoir des significations identiques ou différentes,

$R^4$ : -(-$CH_2CH_2$-O-$)_n$-H, n étant un nombre entier allant de 1 à 15,
alkyle en C12, en C14, en C16 ou en C18,
3-azatridécan-1-yle à 3-azadocosan-1-yle,
4-azatridécan-1-yle à 4-azadocosan-1-yle,
3-aza-4-oxo-tridécan-1-yle à 3-aza-4-oxo-docosan-1-yle,
4-aza-5-oxo-tridécan-1-yle à 4-aza-5-oxo-docosan-1-yle,
3-oxa-tridécan-1-yle à 3-oxa-docosan-1-yle,
4-oxa-tridécan-1-yle à 4-oxa-docosan-1-yle,
2-hydroxy-4-oxo-tridécan-1-yle à 2-hydroxy-4-oxa-docosan-1-yle;

iii) les éther-amines primaires de formule générale III

$$R^5\text{-}O\text{-}R^6\text{-}NH_2 \qquad (III)$$

dans laquelle les symboles ont les significations suivantes :

$R^5$ : alkyle en C6-C20 et
$R^6$ : alcanediyle en C2-C6 ; et/ou

iv) les sels de métaux alcalins, alcalino-terreux et/ou de métaux de transition des acides aminocarboxyliques.

**2.** Procédé selon la revendication 1, caractérisé par le fait que le solvant révélateur organique a une conductivité électrique $\sigma \geq 100$ pS.

**3.** Procédé selon une des revendications 1 ou 2, caractérisé par le fait que le solvant révélateur organique contient au moins une fraction de pétrole désaromatisée.

**4.** Procédé selon la revendication 1, caractérisé par le fait que l'on utilise, en tant qu'agent antistatique (iv), un mélange d'anthranilate de chromane et de semialanate de calcium.

**5.** Procédé selon la revendication 1, caractérisé par le fait que l'on utilise, en tant qu'agent antistatique (iii), la 3-hexyloxyprop-1-ylamine.

6. Procédé selon une des revendications 1 à 5, caractérisé par le fait que le solvant révélateur organique contient un antioxydant soluble en proportions efficaces.

7. Procédé selon une des revendications 1 à 6, caractérisé par le fait que le solvant révélateur organique contient au moins un alcool saturé à radical alkyle ramifié dans la molécule, pratiquement inodore, adapté par son point d'ébullition ou son intervalle d'ébullition à l'intervalle d'ébullition du solvant révélateur organique, et/ou de l'alcool benzylique.

8. Procédé selon la revendication 7, caractérisé par le fait que le solvant révélateur organique contient l'alcool en proportions de 5 à 50 % en volume.

9. Procédé selon la revendication 7 ou 8, caractérisé par le fait que l'on utilise, en tant qu'alcool saturé à radical ramifié dans la molécule, l'isoheptanol, l'isooctanol, l'isononanol, le 3,5,5-triméthylhexanol, le 2-éthylhexanol et/ou un mélange industriel d'alcools saturés à radical alkyle ramifié dans la molécule.